# EUROPEAN PATENT APPLICATION

(11) **EP 2 605 630 A2**
(43) Date of publication of application: **19.06.2013**
(21) Application number: 12189717.7
(22) Date of filing: 24.10.2012
(51) Int. Cl.: H05K 13/02, H05K 13/08

(54) **Jig specification support device, jig specification support method and jig specification support program**

(30) Priority: 14.12.2011 JP 2011273889
(71) Applicant: FUJITSU LIMITED, Kawasaki-shi, Kanagawa 211-8588 (JP)
(72) Inventor: Okada, Hiroyuki, Ishikawa 929-1196 (JP); Iida, Mitsuhiro, Ishikawa 929-1196 (JP); Miyashita, Yoshie, Ishikawa 929-1196 (JP)
(74) Representative: HOFFMANN EITLE

(57) **Abstract**

A part operation support device(11) is connected to a database(12) that stores a first identifier which identifies an electronic part(20A) to be mounted on a substrate unit using a mounter device(17) and a second identifier which identifies a jig(20) mounting the electronic part in a corresponding manner. The part operation support device(11) includes a supplement determination unit(54) that determines whether total number of electronic parts mounted on one or more jigs mounted on the mounter device(17) is less than the number requested to achieve a plan. Further, the part operation support device(11) includes a fourth display control unit(58) that, when the total number of electronic parts is less than the number, specifies the second identifier of the jig which is not mounted on the mounter device(17) and is mounting the electronic part. Further, the fourth display control unit(58) emits a LED(20E) of the jig(20) having the specified second identifier.

## Description

### FIELD

The embodiment discussed herein is directed to a jig specification support device, a jig specification support method and a jig specification support program.

### BACKGROUND

Conventionally, a substrate unit in which electronic parts are mounted on a print substrate is produced in a manufacturing line equipped with a mounter device or a reflow device. For example, in the manufacturing line, a part mount device such as the mounter device mounts an electronic part on the print substrate supplied from the manufacturing line. Subsequently, the reflow device fixes the electronic part mounted on the print substrate by solder hardened by a thermal processing. The mounter device is one of key devices that determine a production capability of the substrate unit in the manufacturing line.

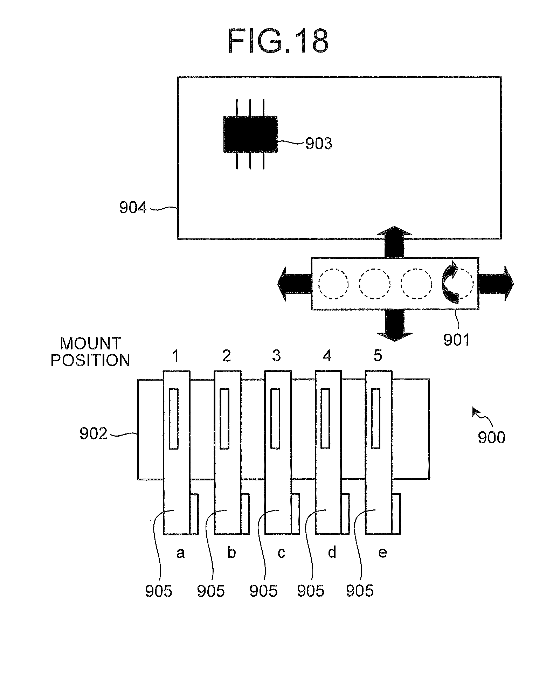

The operations of the mounter device will be described below by way of specific examples. FIG. 18 is an explanatory diagram illustrating exemplary operations of arranging an electronic part by the mounter device. A mounter device 900 illustrated in FIG. 18 absorbs an electronic part 903 to an absorption head 901 from a jig 905 mounted at a mount position 902, and mounts the absorbed electronic part 903 at a predetermined position on a print substrate 904. The jig 905 mounting the electronic part 903 thereon is mounted at the mount position 902 in the mounter device 900 by a worker before a substrate unit starts being produced. For example, the mounter device 900 illustrated in FIG. 18 is provided with the mount position 902 assigned with address numbers, and the worker mounts the jig 905 mounting the electronic part 903 thereon at the mount position 902 with a predetermined address number.

There will be described below a work that the worker mounts the jig 905 mounting the electronic part 903 thereon on the mounter device 900. There will be described herein a case in which the mounter device 900 produces a substrate unit mounting electronic parts "a, b, c, d, e" thereon in plan A, and after completing plan A, the mounter device 900 produces a substrate unit mounting electronic parts "h, i, b, k" thereon in plan B by way of example.

The worker collects the electronic parts 903 stored in a managed storage and ships them to a site with reference to a paper list describing the electronic parts 903 used in plan A and plan B therein. The worker mounts the shipped electronic parts 903 on the jigs 905, and stores the jigs 905 mounting the electronic parts 903 thereon in a waiting place. Then, the worker stores the electronic parts 903 and the jigs 905 by units of plan until the electronic parts 903 of plan A and plan B are prepared.

Subsequently, the worker mounts the jigs 905 for the electronic parts 903 requested to achieve plan A on the mounter device 900. In the example illustrated in FIG. 18, the worker mounts the jigs 905 at "1, 2, 3, 4, 5" in the mount position 902 in the order of "a, b, c, d, e" of the electronic parts 903. That is, the worker mounts the jig 905 for the electronic part 903 "a" at the mount position 902 with address "1", and mounts the jig 905 for the electronic part 903 "b" at the mount position 902 with address "2." The worker mounts the jig 905 for the electronic part 903 "c" at the mount position 902 with address "3", mounts the jig 905 for the electronic part 903 "d" at the mount position 902 with address "4", and mounts the jig 905 for the electronic part 903 "e" at the mount position 902 with address "5." The operation system uniquely determines a combination of the mount position 902 and the jig 905 for the electronic part 903 by units of plan, and is referred to as a fixed arrangement system.

Subsequently, when plan A is completed and plan B is started, the worker performs a stage change work of mounting the jigs 905 for the electronic parts 903 used in plan B at the determined mount position 902 in the mounter device 900. Thus, the worker removes all the jigs 905 for the electronic parts 903 mounted at the mount position 902 in the mounter device 900 every stage change work, and mounts the jigs 905 stored by units of plan at the mount position 902 in the mounter device 900.

In the stage change work, for the electronic parts 903 used in a plurality of plans, the jigs 905 mounting the same electronic parts 903 thereon may be reused. For example, after plan A is completed, the worker mounts the jig 905 for the electronic part 903 "b" used in plan A on the mounter device 900 also in plan B. In this way, the jig 905 for the electronic part 903 "b" is reused, thereby alleviating workloads of the worker and reducing stocks of the electronic parts 903.

As another operation system, the mounter device 900 may determine a combination of the mount position 902 and the jig 905 for the electronic part 903. With the operation system, a combination of the jig 905 and the electronic part 903 is previously stored in a memory provided in the jig 905. When the jig 905 is mounted on the mounter device 900, the mounter device 900 reads the memory in the jig 905, and automatically determines a combination of the mount position 902 and the electronic part 903. Then, the mounter device 900 mounts the determined electronic part 903 at an accurate position on the print substrate, and thus the worker may mount the electronic part 903 at the mount position 902 with any address in the mounter device 900. The operation system is referred to as a free arrangement system, and is able to further alleviate workloads of the worker than the aforementioned fixed arrangement system.

Specifically, when the jigs 905 for the electronic parts 903 "a, b, c, d, e" are operated with the free arrangement system, the worker is able to arrange the jigs 905 for the electronic parts 903 "a, b, c, d, e" or "b, a, d, e, c" at "1, 2, 3, 4, 5" on the mount position 902 in any order.
Patent Literature 1: Japanese Laid-open Patent Publication No. 10-209681
Patent Literature 2: Japanese Laid-open Patent Publication No. 10-034459

When the number of remaining electronic parts 903 requested to achieve the production plan in the jigs 905 mounted at the mount position 902 in the mounter device 900 reaches zero, the electronic parts 903 run short and the production of the substrate units is interrupted.

Thus, the worker searches the jigs 905 mounting the electronic parts 903 to be supplemented from the waiting place, and mounts the searched jigs 905 on the mounter device 900, thereby supplementing the lacking electronic parts 903 on the mounter device 900.

However, since a large number of similar electronic parts 903 are stored in the waiting place, the worker searches the electronic parts 903 to be supplemented from the waiting place with large workloads.

Accordingly, it is an object in one aspect of an embodiment of the invention to provide a jig specification support device, a jig specification support method and a jig specification support program capable of alleviating workloads when searching parts to be supplemented.

### SUMMARY

According to an aspect of the embodiments, a jig specification support device includes a storage unit that stores therein a first identifier which identifies a part to be mounted on a substrate unit using a part mount device and a second identifier which identifies a jig mountable on the part mount device and capable of mounting the part in association with the first identifier; a determination unit that determines whether the total number of parts mounted on one or more jigs mounted on the part mount device is less than a predetermined number; and a display control unit that, when the determination unit determines that the total number of parts is less than the predetermined number, specifies in the storage unit the second identifier of the jig which is not mounted on the part mount device and is mounting the part, and controls a display unit of the jig having the specified second identifier.

### BRIEF DESCRIPTION OF DRAWINGS

FIG. 1 is an explanatory diagram illustrating an exemplary electronic part arrangement system according to an embodiment;
FIG. 2 is a front view illustrating an exemplary waiting station;
FIG. 3 is a block diagram illustrating an exemplary part operation support device;
FIG. 4 is an explanatory diagram illustrating exemplary information stored in a cassette condition DB;
FIG. 5 is an explanatory diagram illustrating exemplary information stored in a mounter device DB;
FIG. 6 is an explanatory diagram illustrating exemplary information stored in a plan DB;
FIG. 7 is an explanatory diagram illustrating exemplary information stored in a unit figure number DB;
FIG. 8 is an explanatory diagram illustrating exemplary information stored in a jig-part combination DB;
FIG. 9 is an explanatory diagram illustrating exemplary information stored in a product DB;
FIG. 10 is an explanatory diagram illustrating exemplary information stored in a jig-RF tag combination DB;
FIG. 11 is an explanatory diagram illustrating exemplary information stored in a RF antenna DB;
FIG. 12 is a flowchart illustrating exemplary operations by a control unit for a stage change support processing;
FIG. 13 is a flowchart illustrating exemplary processing operations by the control unit for a processing of reporting a part to be removed;
FIG. 14 is a flowchart illustrating exemplary processing operations by the control unit for a processing of reporting a part to be mounted;
FIG. 15 is a flowchart illustrating exemplary processing operations by the control unit for a processing of reporting a part to be supplemented;
FIG. 16 is a flowchart illustrating exemplary processing operations by the control unit for a processing of reporting a part to be supplemented;
FIG. 17 is an explanatory diagram illustrating an exemplary computer that executes a part operation support program; and
FIG. 18 is an explanatory diagram illustrating exemplary operations by the mounter device that arranges electronic parts.

### DESCRIPTION OF EMBODIMENTS

Preferred embodiment of the present invention will be explained with reference to accompanying drawings. The disclosed technique is not limited to the present embodiment.

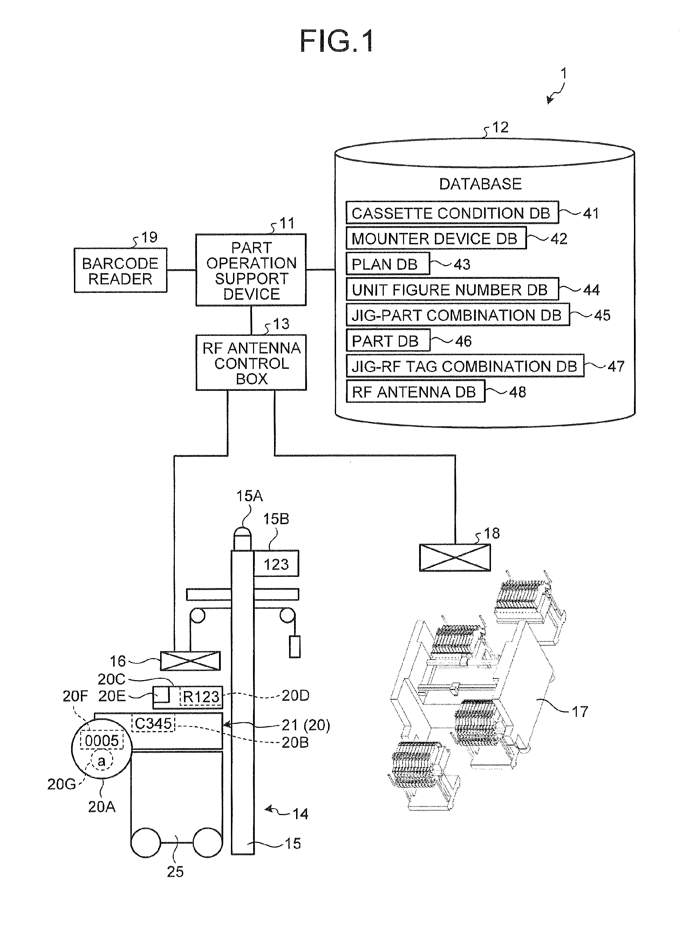

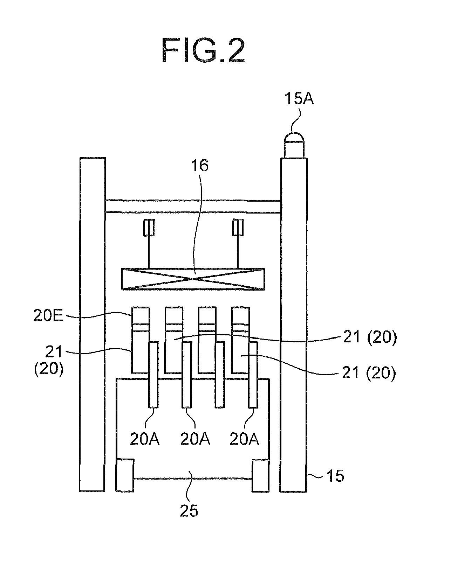

FIG. 1 is an explanatory diagram illustrating an exemplary structure of an electronic part arrangement system according to the present embodiment. FIG. 2 is a front view illustrating an exemplary waiting station. An electronic part arrangement system 1 illustrated in FIG. 1 includes a part operation support device 11, a database 12, and an RF (Radio Frequency) antenna control BOX 13. The electronic part arrangement system 1 further includes a waiting station 15 inside a waiting place 14, an RF antenna 16 on the side of the waiting station 15, a mounter device 17, and an RF antenna 18 on the side of the mounter device 17. The electronic part arrangement system 1 configures part of a SMT (Surface Mount Technology) line for substrate units.

The SMT line includes a substrate supply device, a screen printing machine, the mounter device 17, a reflow device and a substrate accommodation device. The substrate supply device supplies print substrates to the manufacturing line. The screen printing machine prints solder paste at the solder positions on the print substrate. The mounter device 17 mounts electronic parts at designated positions on the print substrate. The reflow device hardens the solder by a heat processing. The substrate accommodation device accommodates the completed substrate units in a magazine.

The waiting place 14 is a space that a worker stores jigs 20 mounting electronic parts 20A thereon. For example, the worker collects the electronic parts 20A stored in a managed storage (not illustrated), ships the collected electronic parts 20A to a site, and mounts the shipped electronic parts 20A on the jigs 20. Then, the worker stores the jigs 20 mounting the electronic parts 20A thereon in the waiting station 15 in the waiting place 14. A shelf (not illustrated) and truck 25 that stores the jigs 20 are arranged in the waiting station 15. The truck 25 enables the stored jigs 20 to be carried.

The worker performs a work of mounting the electronic parts 20A on the jigs 20 until all the electronic parts 20A requested to achieve a production plan of the substrate units are prepared. The electronic parts 20A, which are not used in the future product plans, are removed from the jigs 20 and returned to the managed storage by the worker. The electronic parts 20A which are not used in the future production plans and are removed from the jigs 20 are referred to as disassembled parts.

The jig 20 may be a cassette jig 21 that mounts a reel-shaped electronic part 20A or a pallet jig that mounts the electronic part 20A in a tray. The cassette jig 21 mounts a reel on which a tape storing electronic parts 20A per predetermined pitch is wound, and the tape is intermittently fed out from the reel so that the electronic parts 20A stored in the tape are sequentially supplied to the mounter device 17. The pallet jig includes a tray on which the electronic parts 20A are placed, and is vertically mounted at the mount position of the mounter device 17. The vertically-mounted pallet jig is drawn by the mounter device 17 from the mount position, and the electronic parts 20A in the tray are absorbed by the absorption heads.

The jigs 20 (the cassette jigs 21) mounting the electronic parts 20A are stored in the waiting place 14. The jig 20 is given a jig ID 20B that is an identifier which identifies the jig 20. The jig ID 20B is assigned with a not-overlapped identification number per jig 20, and is "C345" in the example illustrated in FIG. 1. The jig 20 is attached with a barcode or the like recording the jig ID 20B therein.

The jig 20 is attached with an RF tag 20C. The RF tag 20C is given an RF tag ID 20D that is an identifier which identifies the RF tag 20C. The RF tag ID 20D is assigned with a not-overlapped identification number per RF tag 20C, and is "R123" in the example illustrated in FIG. 1.

The RF tag 20C incorporates an LED (Light Emitting Diode) 20E therein, and receives a command via the RF antenna 16 (18) and supplies power. Then, the RF tag 20C emits the LED 20E in response to the command. When receiving the command, the RF tag 20C reads its own RF tag ID 20D, and transmits the read RF tag ID 20D to the part operation support device 11 via the RF antenna 16 (18).

The electronic part 20A is given a part ID 20F and a part figure number 20G that are identifiers which identify an electronic part 20A. The part ID 20F is assigned with a not-overlapped identification number per electronic part 20A, and is "0005" in the example illustrated in FIG. 1. The part figure number 20G is "a" in the example illustrated in FIG. 1.

The electronic part 20A contains a moisture absorption management part that manages and handles moisture absorption. A time is predetermined in which the moisture absorption management part is able to be stored under the circumstances with normal temperature and normal humidity until it is put into the reflow device after it is taken out from the moisture absorption storage or the like. Thus, when the predetermined time is exceeded, the moisture absorption management part is subjected to a heating processing at a determined temperature for a designated time and its inside water is removed, and then is reused. Therefore, the moisture absorption management part is accommodated in a sealed moisture absorption storage or the like whose humidity is able to be managed. The waiting place 14 is provided with a moisture absorption storage and stores the moisture absorption management part therein.

The waiting place 14 is arranged with a plurality of waiting stations 15. The waiting station 15 includes a display light 15A and a display unit 15B. The display light 15A lights to report that the jig 20 mounting the specified electronic part 20A thereon is stored in the relevant waiting station 15 in response to a command from the part operation support device 11 via the RF antenna 16. The display unit 15B identifies an address number of the mount position where the jig 20 is mounted on the mounter device 17 in response to a command from the part operation support device 11, for example, when the jig 20 for the specified electronic part 20A is a jig 20 for an electronic part 20A with the fixed arrangement system.

The mounter device 17 sequentially mounts the electronic parts 20A in the jigs 20 mounted at the mount positions onto the designated positions on the print substrate according to the production plan. For example, the mounter device 17 acquires the electronic parts 20A from a reel mounted on the cassette jig 21 or a tray placed on the pallet jig, and mounts the acquired electronic parts 20A on the print substrate.

The part operation support device 11 is connected to a barcode reader 19, the database 12 or the RF antenna control BOX 13 via LAN (Local Area Network) or wireless communication, for example. When the electronic part 20A is mounted in the jig 20, the barcode reader 19 reads barcodes attached on the electronic part 20A and the jig 20, and creates information on the electronic part 20A and the jig 20 in a one-to-one correspondence.

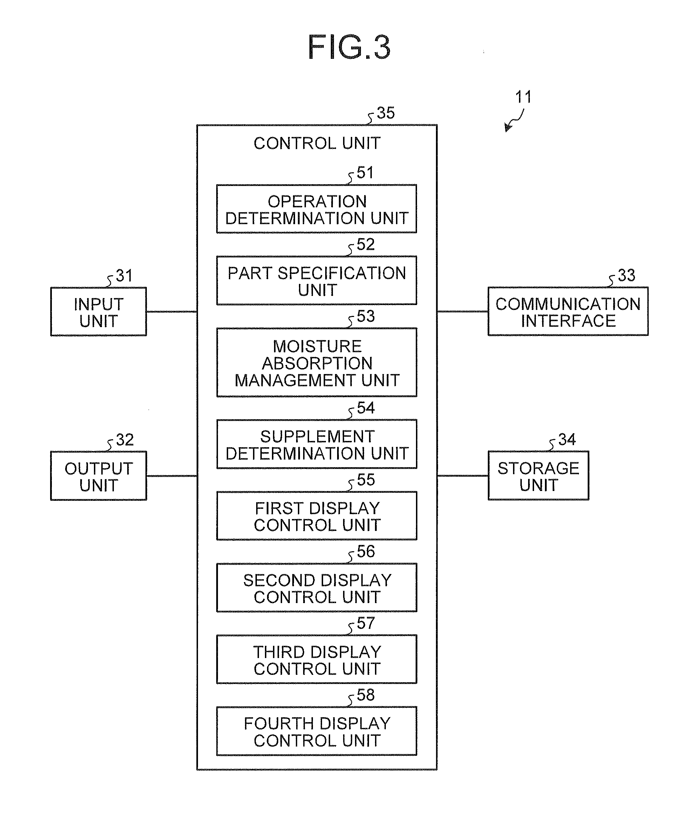

FIG. 3 is a block diagram illustrating an exemplary part operation support device 11. The part operation support device 11 illustrated in FIG. 3 includes an input unit 31, an output unit 32, a communication interface 33, a storage unit 34 and a control unit 35. The input unit 31 is a keyboard, a mouse or a touch panel, for example, and is directed to input various items of information on input of production plan, removal work and mount work by the worker. The output unit 32 is a monitor, a display or a touch panel, for example, and is directed to output various items of information on the mount positions of the electronic parts 20A received from the control unit 35, or an out-of-storage time of the moisture absorption management part.

The communication interface 33 includes a communication port (not illustrate), and is an interface that communicates with the barcode reader 19, the database 12 and the RF antenna control BOX 13, for example The storage unit 34 is directed to store various items of information such as control programs, programs defining various processings, or predetermined data. The control unit 35 is directed to entirely control the part operation support device 11.

The database 12 includes a cassette condition DB 41, a mounter device DB 42, a plan DB 43, a unit figure number DB 44, a jig-part combination DB 45, a part DB 46, a jig-RF tag combination DB 47, and a RF antenna DB 48.

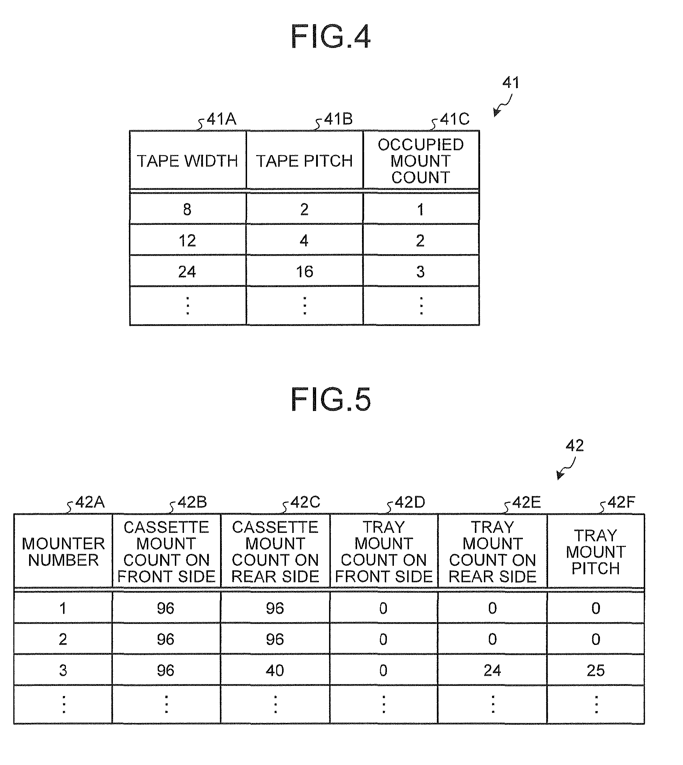

FIG. 4 is an explanatory diagram illustrating exemplary information stored in the cassette condition DB 41. The cassette condition DB 41 illustrated in FIG. 4 stores a tape width 41A, a tape pitch 41B, and an occupied mount count 41C per cassette jig 21 in a corresponding manner. The tape width 41A indicates a tape width of the cassette jig 21, and "8", "12" or "24" is stored therefor, for example. The tape pitch 41B indicates a storage pitch of the electronic parts 20A, and "2", "4" or "16" is stored therefor, for example. The occupied mount count 41C indicates the number of occupied mount positions when the cassette jigs 21 are mounted at mount positions in the mounter device 17 according to the tape width 41A and the tape pitch 41B, and "1", "2", or "3" is stored therefor, for example.

The cassette condition DB 41 illustrated in FIG. 4 indicates that the occupied mount count 41C for mounting the cassette jigs 21 with the tape width 41A of 8 mm and the tape pitch 41B of 2 mm is one. Similarly, it indicates that the occupied mount count 41C for mounting the cassette jigs 21 with the tape width 41A of 12 mm and the tape pitch 41B of 4 mm is two and the occupied mount count 41C for mounting the cassette jigs 21 with the tape width 41A of 24 mm and the tape pitch 41B of 16 mm is three.

FIG. 5 is an explanatory diagram illustrating exemplary information stored in the mounter device DB 42. The mounter device DB 42 illustrated in FIG. 5 stores the number of mount positions of the cassette jigs 21 or the tray jigs per mounter device 17 therein. For example, the mounter device DB 42 illustrated in FIG. 5 stores therein a mounter number 42A, a cassette mount count (front side) 42B, a cassette mount count (rear side) 42C, a tray mount count (front side) 42D, a tray mount count (rear side) 42E, and a tray mount pitch 42F in a corresponding manner.

The mounter number 42A indicates an identifier that identifies the mounter device 17, and "1", "2" or "3" is stored therefor, for example. The cassette mount count (front side) 42B indicates a maximum mountable number of the cassette jigs 21 mountable on the front face of the mounter device 17, and "96" is stored therefor, for example. The cassette mount count (rear side) 42C indicates a maximum mountable number of the cassette jigs 21 mountable on the rear face of the mounter device 17, and "40" or "96" is stored therefor, for example. The tray mount count (front side) 42D indicates a maximum mountable number of the pallet jigs mountable on the front face of the mounter device 17, and "0" is stored therefor, for example. The tray mount count (rear side) 42E indicates a maximum number of the pallet jigs mountable on the rear face of the mounter device 17, and "0" or "24" is stored therefor, for example. The tray mount pitch 42F indicates a mount pitch of the pallet jigs, and "0" or "25" is stored therefor, for example.

With reference to the mounter device DB 42 illustrated in FIG. 5, it is indicated that the mounter device 17 with the mounter number 42A of "1" is able to mount 96 cassette jigs 21 on the front face and 96 cassette jigs 21 on the rear face. It is indicated that the mounter device 17 with the mounter number 42A of "2" is able to mount 96 cassette jigs 21 on the front face and 96 cassette jigs 21 on the rear face. Similarly, it is indicated that the mounter device 17 with the mounter number 42A of "3" is able to mount 96 cassette jigs 21 on the front face, 40 cassette jigs 21 on the rear face and 24 pallet jigs on the rear face.

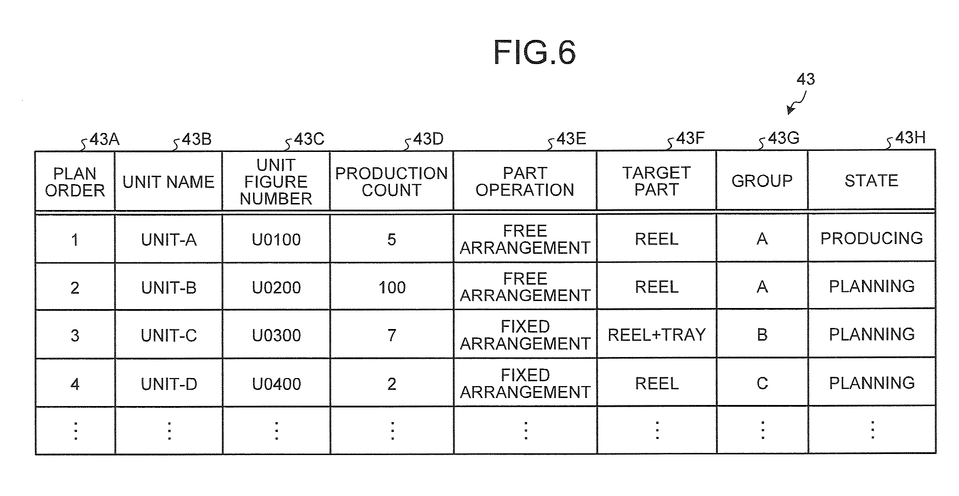

FIG. 6 is an explanatory diagram illustrating exemplary information stored in the plan DB 43. The plan DB 43 illustrated in FIG. 6 stores therein a plan order 43A, a unit name 43B, a unit figure number 43C, a production count 43D, a part operation 43E, a target part 43F, a group 43G and a state 43H in a corresponding manner.

The plan order 43A indicates a plan order of the substrate units to be produced, and "1", "2", "3" or "4" is stored therefor, for example. The unit name 43B indicates an identifier that identifies a substrate unit to be produced, and "UNIT-A", "UNIT-B", "UNIT-C" or "UNIT-D" is stored therefor, for example. The unit figure number 43C indicates a figure number of the substrate unit, and "U0100", "U0200", "U0300" or "U0400" is stored therefor, for example. The production count 43D indicates the number of substrate units to be produced, and "5", "100", "7" or "2" is stored therefor, for example. The part operation 43E indicates an operation system of the electronic parts 20A mounted on the mounter device 17, which is set per production plan, and "fixed arrangement" or "free arrangement" is stored therefor, for example. The target part 43F indicates a storage form of the electronic parts 20A mounted on the substrate unit, and "reel" or "reel + tray" is stored therefor, for example. The group 43G indicates a group name of the production plan that changes stages at the same time, and "A", "B" or "C" is stored therefor, for example. The state 43H indicates a progress state of the production plan, and "producing" or "planning" is stored therefor, for example.

With reference to the plan DB 43 illustrated in FIG. 6, the plan with the plan order 43A of "1" is that five "UNIT-A" with the unit figure number 43C of "U0100" is being produced. Further, the production of "UNIT-A" indicates that the reel-shaped electronic parts 20A are mounted on the mounter device 17 in the free arrangement system and the stage is changed at the same time with the group 43G of "A." Similarly, the plan with the plan order 43A of "2" is that 100 "UNIT-B" with the unit figure number 43C of "U0200" are to be produced. Further, it is indicated that for the production of "UNIT-B", the reel-shaped electronic parts 20A are mounted on the mounter device 17 in the free arrangement system and the stage is changed at the same time with the group 43G of "A."

Similarly, the plan with the plan order 43A of "3" is that seven "UNIT-C" with the unit figure number 43C of "U0300" are to be produced. Further, it is indicated that for the production of "UNIT-C", the reel-shaped electronic parts 20A and the tray-shaped electronic parts 20A are mounted on the mounter device 17 in the fixed arrangement system and the stage is changed at the same time with the group 43G of "B." Similarly, the plan with the plan order 43A of "4" is that two "UNIT-D" with the unit figure number 43C of "U0400" is to be produced. Further, it is indicated that for the production of "UNIT-D", the reel-shaped electronic parts 20A are mounted on the mounter device 17 in the fixed arrangement system and the stage is changed at the same time with the group 43G of "C."

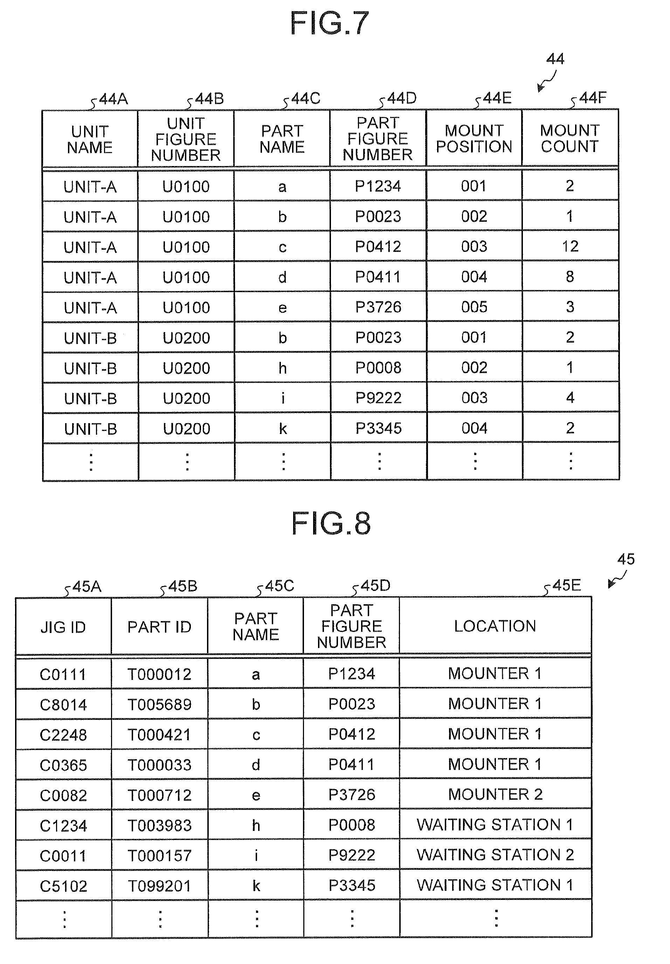

FIG. 7 is an explanatory diagram illustrating exemplary information stored in the unit figure number DB 44. The unit figure number DB 44 illustrated in FIG. 7 stores information on the electronic parts 20A used for the substrate units therein. The unit figure number DB 44 stores therein a unit name 44A, a unit figure number 44B, a part name 44C, a part figure number 44D, a mount position 44E and a mount count 44F per substrate unit in a corresponding manner.

The unit name 44A and the unit figure number 44B are the same as the information stored in the plan DB 43 and thus a detailed explanation thereof will be omitted. The part name 44C indicates a name of each electronic part 20A, and "a", "b", "c", "d" or "e" is stored therefor, for example. The part figure number 44D indicates a figure number of the electronic part 20A, and "P1234", "P0023", "P0412", "P0411" or "P3726" is stored therefor, for example. The mount position 44E indicates an address number of the mount position where the electronic part 20A is mounted on the mounter device 17, and "001", "002", "003", "004" or "005" is stored therefor, for example. The mount count 44F indicates the number of electronic parts 20A used in the production of each substrate unit, and "2", "1", "12", "8" or "3" is stored therefor, for example.

With reference to the unit figure number DB 44 illustrated in FIG. 7, it is indicated that two electronic parts "a" with the part figure number 44D of "P1234" are used for the substrate unit "UNIT-A" with the unit figure number 44B of "U0100." It is further indicated that the jigs 20 mounting the electronic parts "a" thereon are mounted at the mount positions with the address number "001" in the mounter device 17. Similarly, it is indicated that one electronic part "b" with the part figure number 44D of "P0023" is used for the substrate unit "UNIT-A" with the unit figure number 44B of "U0100." Further, it is indicated that the jig 20 mounting the electronic part "b" is mounted at the mount position with the address number "002" in the mounter device 17.

Similarly, it is indicated that 12 electronic parts "c" with the part figure number 44D of "P0412" are used for the substrate unit "UNIT-A" with the unit figure number 44B of "U0100." Further, it is indicated that the jigs 20 mounting the electronic parts "c" are mounted at the mount positions with the address number "003" in the mounter device 17. Similarly, it is indicated that eight electronic parts "d" with the part figure number 44D of "P0411" are used for the substrate unit "UNIT-A" with the unit figure number 44B of "U0100." Further, it is indicated that the jigs 20 for the electronic parts "d" are mounted at the mount positions with the address number of "004" in the mounter device 17. Similarly, it is indicated that three electronic parts "e" with the part figure number 44D of "P3726" are used for the substrate unit "UNIT-A" with the unit figure number 44B of "U0100." Further, it is indicated that the jigs 20 mounting the electronic parts "e" thereon are mounted at the mount positions with the address number "005" in the mounter device 17.

FIG. 8 is an explanatory diagram illustrating exemplary information stored in the jig-part combination DB 45. The jig-part combination DB 45 illustrated in FIG. 8 stores a combination of the jig 20 and the electronic part 20A therein. The jig-part combination DB 45 illustrated in FIG. 8 stores therein a jig ID 45A, a part ID 45B, a part name 45C, a part figure number 45D and a location 45E per jig 20 in a corresponding manner.

The jig ID 45A is an identifier that identifies a jig 20, and "C1234", "C8014" or "C5102" is stored therefor, for example. The part ID 45B is an identifier that identifies an electronic part 20A mounted on the jig 20, and "T003983", "T005689" or "T099201" is stored therefor, for example. The part name 45C and the part figure number 45D are the same as the information stored in the unit figure number DB 44, and thus a detailed explanation thereof will be omitted. The location 45E indicates a present location of the jig 20 mounting the electronic part 20A thereon, and "waiting station" or "mounter" is stored therefor, for example.

The jig-part combination DB 45 illustrated in FIG. 8 indicates that the electronic part "h" with the part ID 45B of "T003983" and the part figure number 45D of "P0008" is combined with the jig 20 with the jig ID 45A of "C1234" and the jig 20 is located at "waiting station 1" currently

Similarly, it is indicated that the electronic part "b" with the part ID 45B of "T005689" and the part figure number 45D of "P0023" is combined with the jig 20 with the jig ID 45A of "C8014" and the jig 20 is mounted on "mounter 1" currently. It is indicated that the electronic part "k" with the part ID 45B of "T099201" and the part figure number 45D of "P3345" is combined with the jig 20 with the jig ID 45A of "C5102" and the jig 20 is located at "waiting station 1" currently.

The jig-part combination DB 45 is generated when the electronic part 20A shipped by the worker is mounted on the jig 20. When the worker combines the electronic part 20A and the jig 20, the part operation support device 11 uses the barcode reader 19 to read the IDs of the electronic part 20A and the jig 20, and associates the electronic part 20A and the jig 20 one-to-one based on the read IDs. The part operation support device 11 associates the electronic part 20A with the jig 20, and updates the jig-part combination DB 45 in the database 12.

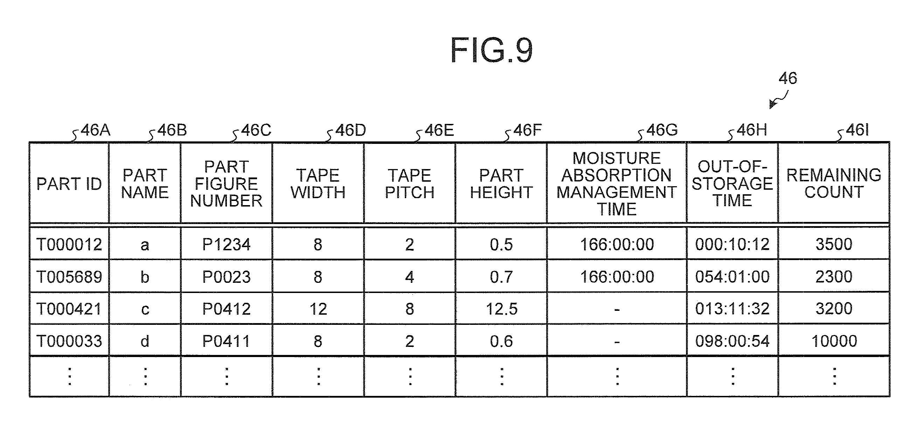

FIG. 9 is a diagram illustrating exemplary information stored in the part DB 46. The part DB 46 illustrated in FIG. 9 stores therein a part ID 46A, a part name 46B, a part figure number 46C, a tape width 46D, a tape pitch 46E, a part height 46F, a moisture absorption management time 46G, an out-of-storage time 46H and a remaining count 46I per electronic part 20A in a corresponding manner.

The part ID 46A, the part name 46B and the part figure number 46C are the same as the information stored in the jig-part combination DB 45, and thus a detailed explanation thereof will be omitted. The tape width 46D and the tape pitch 46E are the same as the information stored in the cassette condition DB 41, and thus a detailed explanation thereof will be omitted. The part height 46F indicates a height of the electronic part 20A, and "0.5", "0.7", "12.5" or "0.6" is stored therefor, for example. The moisture absorption management time 46G indicates an upper limit of the time in which the moisture absorption management part is able to be stored under circumstances with normal temperature and normal humidity until it is put into the reflow device after it is taken out of the moisture absorption storage, and "166:00:00" is stored therefor, for example. The out-of-storage time 46H indicates an accumulated time in which the moisture absorption management part is exposed to normal temperature and normal humidity, and "000:10:12", "054:01:00", "013:13:32" or "098:00:54" is stored therefor, for example. The remaining count 46I indicates the number of remaining electronic parts 20A, and "3500", "2300", "3200" or "10000" is stored therefore, for example.

With reference to the part DB 46 illustrated in FIG. 9, it is indicated that for the electronic part "a" with the part ID 46A of "T000012" and the part figure number 46C of "P1234", the tape width 46D is 8 mm, the tape pitch 46E is 2 mm, the part height 46F is 0.5 mm, and the remaining count 461 is 3500. Further, for the electronic part "a", the out-of-storage time 46H is 10 minutes 12 seconds and is within the upper limit of the moisture absorption management time 46G. Similarly, it is indicated that for the electronic part "b" with the part ID 46A of "T005689" and the part figure number 46C of "P0023", the tape width 46D is 8 mm, the tape pitch 46E is 4 mm, the part height 46F is 0.7 mm, and the remaining count 46I is 2300. For the electronic part "b", the out-of-storage time 46H is 54 hours 1 minute and is within the upper limit of the moisture absorption management time 46G.

It is indicated that for the electronic part "c" with the part ID 46A of "T000421" and the part figure number 46C of "P0412", the tape width 46D is 12 mm, the tape pitch 46E is 8 mm, the part height 46F is 12.5 mm, and the remaining count 46I is 3200. Further, the electronic part "c" has the out-of-storage time 46H of 13 hours 11 minutes 32 seconds, but is not a moisture absorption management part. Similarly, it is indicated that for the electronic part "d" with the part ID 46A of "T000033" and the part figure number 46C of "P0411", the tape width 46D is 8 mm, the tape pitch 46E is 2 mm, the part height 46F is 0.6 mm, and the remaining count 46I is 10000. Further, the electronic part "d" has the out-of-storage time 46H of 98 hours 54 seconds, but is not a moisture absorption management part.

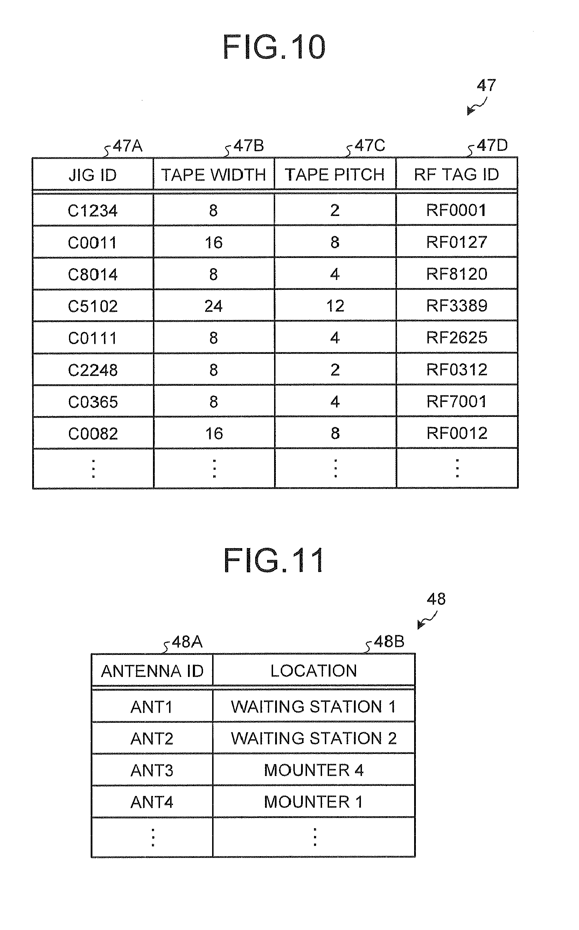

FIG. 10 is an explanatory diagram illustrating exemplary information stored in the jig-RF tag combination DB 47. The jig-RF tag combination DB 47 stores a combination of the jig 20 and the RF tag 20C therein. The jig-RF tag combination DB 47 illustrated in FIG. 10 stores therein a jig ID 47A, a tape width 47B, a tape pitch 47C and an RF tag ID 47D in a corresponding manner.

The jig ID 47A is the same as the information stored in the jig-part combination DB 45 and thus a detailed explanation thereof will be omitted. The tape width 47B and the tape pitch 47C are the same as the information stored in the cassette condition DB 41, and thus a detailed explanation thereof will be omitted. The RF tag ID 47D is an identifier that identifies the RF tag 20C, and "RF0001", "RF0127", "RF8120" or "RF3389" is stored therefor, for example.

The jig-RF tag combination DB 47 illustrated in FIG. 10 indicates that the RF tag 20C with the RF tag ID 47D of "RF0001" is attached to the jig 20 with the jig ID 47A of "C1234", the tape width 47B of 8 mm and the tape pitch 47C of 2 mm. Similarly, it is indicated that the RF tag 20C with the RF tag ID 47D of "RF0127" is attached to the jig 20 with the jig ID 47A of "C0011", the tape width 47B of 16 mm and the tape pitch 47C of 8 mm.

Similarly, it is indicated that the RF tag 20C with the RF tag ID 47D of "RF8120" is attached to the jig 20 with the jig ID 47A of "C8014", the tape width 47B of 8 mm, and the tape pitch 47C of 4 mm. Further, it is indicated that the RF tag 20C with the RF tag IF 47D of "RF3389" is attached to the jig 20 with the jig ID 47A of "C5102", the tape width 47B of 24 mm and the tape pitch 47C of 12 mm.

FIG. 11 is an explanatory diagram illustrating exemplary information stored in the RF antenna DB 48. The RF antenna DB 48 illustrated in FIG. 11 stores therein "ANT1, waiting station 1", "ANT2, waiting station 2", "ANT3, mounter 4" and "ANT4, mounter 1" as antenna IDs 48A and locations 48B.

The antenna ID 48A is an identifier that identifies the RF antenna 16 or 18, and "ANT1, "ANT2", "ANT3" or "ANT4" is stored therefor, for example. The location 48B indicates where the RF antenna 16 or 18 is installed, and "waiting station 1", "waiting station 2", "mounter 4" or "mounter 1" is stored therefor, for example.

In the example of FIG. 11, the RF antenna DB 48 indicates that the RF antenna 16 identified with "ANT1" is installed at "waiting station 1" and the RF antenna 16 identified with "ANT2" is installed at "waiting station 2." The RF antenna DB 48 indicates that the RF antenna 18 identified with "ANT3" is installed at "mounter 4" and the RF antenna 18 identified with "ANT4" is installed at "mounter 1."

The RF antenna control BOX 13 uses the RF antenna 16 specified by the antenna ID in a command from the part operation support device 11, for example, to transmit a command to the RF tag 20C of the jig 20 in the waiting station 15 specified by the RF tag ID in the command. The RF tag 20C of the jig 20 in the waiting station 15 emits the LED 20E in response to the command via the RF antenna 16. When receiving the command, the RF tag 20C reads the RF tag ID and transmits the read RF tag ID to the part operation support device 11.

The RF antenna control BOX 13 uses the RF antenna 18 specified by the antenna ID in a command from the part operation support device 11, for example, to transmit a command to the RF tag 20C of the jig 20 being mounted on the mounter device 17 specified by the RF tag ID in the command. The RF tag 20C of the jig 20 mounted on the mounter device 17 emits the LED 20E in response to the command via the RF antenna 18. When receiving the command, the RF tag 20C reads the RF tag ID and transmits the read RF tag ID to the part operation support device 11.

The control unit 35 in the part operation support device 11 transmits information associating the received RF tag ID with the antenna ID indicating the reception source to the control unit 35. Consequently, the control unit 35 is able to specify the location of the RF tag 20C based on the antenna ID. The control unit 35 specifies the jig 20 with the corresponding jig ID based on the RF tag ID, and is able to specify the location of the specified jig 20. Consequently, the control unit 35 updates the location of the electronic part 20A and the jig 20 to the latest information and stores it in the jig-part combination DB 45.

The RF antenna control BOX 13 receives a command from a first display control unit 55 described later in the control unit 35. The RF antenna control BOX 13 transmits a command to the RF tag 20C specified with the RF tag ID in the command via the RF antenna 18 on the side of the mounter device 17 specified with the antenna ID in the received command. The RF tag 20C of the jig 20 mounted on the mounter device 17 emits the LED 20E in response to the command. Consequently, the worker is able to identify the jig 20 for the part to be removed, which is mounted on the mounter device 17, in response to the light emission of the LED 20E.

The RF antenna control BOX 13 receives a command from a second display control unit 56 described later in the control unit 35. The RF antenna control BOX 13 transmits a command to the RF tag 20C specified with the RF tag ID in the command via the RF antenna 16 on the side of the waiting station 15 specified with the antenna ID in the received command. The RF tag 20C of the jig 20 in the waiting station 15 emits the LED 20E in response to the command. Consequently, the worker is able to identify the jig 20 for the part to be mounted in the waiting station 15 in response to the light emission of the LED 20E.

The RF antenna control BOX 13 receives a command from a third display control unit 57 described later in the control unit 35. The RF antenna control BOX 13 transmits a command to the RF tag 20C specified with the RF tag ID in the command via the RF antenna 16 on the side of the waiting station 15 specified with the antenna ID in the received command. The RF tag 20C of the jig 20 in the waiting station 15 emits the LED 20E in response to the command. Consequently, the worker is able to identify the jig 20 for the part to be disassembled in the waiting station 15 in response to the light emission of the LED 20E.

The RF antenna control BOX 13 receives a command from a fourth display control unit 58 described later in the control unit 35. The RF antenna control BOX 13 transmits a command to the RF tag 20C specified with the RF tag ID in the command via the RF antenna 16 on the side of the waiting station 15 specified with the antenna ID in the received command. The RF tag 20C of the jig 20 for the part to be supplemented in the waiting station 15 emits the LED 20E in response to the command. Consequently, the worker is able to identify the jig 20 for the part to be supplemented in the waiting station 15 in response to the light emission of the LED 20E.

The control unit 35 includes an operation determination unit 51, a part specification unit 52, a moisture absorption management unit 53, a supplement determination unit 54, the first display control unit 55, the second display control unit 56, the third display control unit 57 and the fourth display control unit 58. For example, the control unit 35 is an integrated circuit such as ASIC (Application Specific Integrated Circuit) or FPGA (Field Programmable Gate Array), or an electronic circuit such as CPU (Central Processing Unit) or MPU (Micro Processing unit).

The operation determination unit 51 determines whether a setting of the stage change work received from the worker is adapted to the setting stored in the plan DB 43. For example, the operation determination unit 51 performs a processing of determining an operation system of an electronic part 20A, a processing of determining a type of an electronic part 20A, and a processing of determining whether a jig 20 for an electronic part 20A to be mounted is mountable on the mounter device 17. Then, the operation determination unit 51 determines the setting of the stage change work received from the worker based on the determination result of each processing.

### [Processing of determining operation system of electronic part 20A]

The operation determination unit 51 determines which of the fixed arrangement system and the free arrangement system the operation system of the electronic part 20A employs. For the sake of a convenience of explanation, there will be described a case in which the free arrangement system is employed for the operation system of the electronic part 20A by way of example. The operation determination unit 51 determines whether the operation system of the electronic part 20A received from the worker and the operation system of the electronic part 20A stored in the plan DB 43 are the free arrangement system.

When determining that both the operation system received from the worker and the operation system stored in the plan DB 43 are the free arrangement system, the operation determination unit 51 performs the "processing of determining a type of an electronic part" described later.

When determining that the operation system stored in the plan DB 43 is the free arrangement system and the operation system received from the worker is not the free arrangement system, the operation determination unit 51 determines that the setting of the stage change work received from the worker is not adapted to the setting stored in the plan DB 43. In this case, the operation determination unit 51 outputs that the setting of the stage change work received from the worker is not adapted to the output unit 32, and notifies it to the worker.

### [Processing of determining type of electronic part 20A]

The operation determination unit 51 determines which of the reel-shaped electronic part 20A and the tray-shaped electronic part 20A the type of the electronic part 20A received from the worker is, and determines whether the type matches with the type of the electronic part 20A stored in the plan DB 43.

When determining that the type of the electronic part 20A received from the worker matches with the type of the electronic part 20A stored in the plan DB 43, the operation determination unit 51 performs the "processing of determining whether the jig 20 for the electronic part 20A to be mounted is mountable on the mounter device 17." When determining that the type of the electronic part 20A received from the worker does not match with the type of the electronic part 20A stored in the plan DB 43, the operation determination unit 51 outputs that the type of the electronic part 20A received from the worker is not adapted to the output unit 32, and notifies it to the worker.

### [Processing of determining whether jig 20 for electronic part 20A to be mounted is mountable on mounter device 17]

The operation determination unit 51 determines whether the jig 20 for the electronic part 20A is mountable on the mounter device 17. The operation determination unit 51 makes a different determination as to whether the jig is mountable on the mounter device 17 between when the type of the electronic part 20A is a reel-shaped electronic part 20A and when the type of the electronic part 20A is a tray-shaped electronic part 20A. Thus, there will be described a determination of the operation determination unit 51 as to whether the jig 20 for the tray-shaped electronic part 20A is mountable on the mounter device 17 after describing a determination as to whether the jig 20 for the reel-shaped electronic part 20A is mountable on the mounter device 17.

### [Determination of reel-shaped electronic part 20A]

There will be described a determination of the operation determination unit 51 as to whether the jig 20 (cassette jig 21) for the reel-shaped electronic part 20A is mountable on the mounter device 17. A plurality of types of the cassette jig 21 is provided by mounter device manufacturers according to the part shape of the electronic part 20A to be mounted. Thus, a type of the cassette jig 21 is different depending on a tape width and a tape pitch. The number of occupied mounts which are mountable at the mount positions of the mounter device 17 is different between a large-size cassette jig mounting a large part with a large reel width and a small-size cassette jig mounting a small part with a small reel width. Thus, for the reel-shaped electronic part 20A, the operation determination unit 51 determines whether all the reel-shaped electronic parts 20A used in the substrate unit are mountable on the mounter device 17.

The operation determination unit 51 acquires a type of the cassette jig 21 mounting the reel-shaped electronic part 20A used for the substrate unit and the mount count 44F of the cassette jigs 21 from the unit figure number DB 44. The operation determination unit 51 acquires the occupied mount count 41C from the cassette condition DB 41 according to the type of the cassette jig 21 such as the tape width and the tape pitch. Then, the operation determination unit 51 acquires a maximum mountable number of the mounter device 17 on which the cassette jigs 21 are mountable from the mounter device DB 42. The operation determination unit 51 determines whether the maximum mountable number of the cassette jigs 21 in the mounter device 17 is equal to or more than the occupied mount count of the jigs 20 for the reel-shaped electronic parts 20A used for the substrate unit.

When determining that the maximum mountable number of the cassette jigs 21 in the mounter device 17 is equal to or more the occupied mount count of the jigs 20 for the reel-shaped electronic parts 20A used for the substrate unit, the operation determination unit 51 determines that the received setting of the stage change work is adapted. Consequently, the input unit 31 is able to receive an instruction of starting the work of removing the electronic part 20A from the worker.

On the other hand, when determining that the maximum mountable number of the cassette jigs 21 in the mounter device 17 is not equal to or more than the occupied mount count of the jigs 20 for the reel-shaped electronic parts 20A used for the substrate unit, the operation determination unit 51 determines that the received setting of the stage change work is not adapted. Then, the operation determination unit 51 outputs that the received setting of the stage change work is not adapted to the output unit 32, and notifies it to the worker.

### [Determination of tray-shaped electronic part 20A]

There will be described a determination of the operation determination unit 51 as to whether the pallet jig for the tray-shaped electronic part 20A is mountable on the mounter device 17. The pallet jig mounting the tray-shaped electronic part 20A thereon is vertically mounted on the mounter device 17. Thus, the pallet jig vertically mounted on the mounter device 17 is mounted at an interval according to the height of the tray-shaped electronic part 20A. Thus, for the tray-shaped electronic part 20A, the operation determination unit 51 determines whether the tray-shaped electronic part 20A used for the substrate unit is mountable on the mounter device 17.

For example, the operation determination unit 51 acquires the mount count 44F of the tray-shaped electronic part 20A used for the substrate unit from the unit figure number DB 44, and acquires the part height of the tray-shaped electronic part 20A from the part DB 46. Further, the operation determination unit 51 acquires the tray mount pitch 42F from the mounter device DB 42, and divides the part height by the tray mount pith to calculate a quotient obtained by rounding up to the whole number as the occupied tray mount count. The operation determination unit 51 acquires the maximum mountable number of the mounter device 17 on which the pallet jigs are mountable from the mounter device DB 42. The operation determination unit 51 determines whether the maximum mountable number of the mounter device 17 is equal to or more than the occupied tray mount count of the jigs 20 for the tray-shaped electronic parts 20A used for the substrate unit.

When determining that the maximum mountable number of the pallet jigs in the mounter device 17 is equal to or more than the occupied tray mount count of the jigs 20 for the tray-shaped electronic parts 20A used for the substrate unit, the operation determination unit 51 determines that the received setting of the stage change work is adapted. Consequently, the input unit 31 is able to receive an instruction of starting the work of removing the electronic parts 20A from the worker.

On the other hand, when determining that the maximum mountable number of the pallet jigs in the mounter device 17 is not equal to or more than the occupied mount count of the jigs 20 for the tray-shaped electronic parts 20A used for the substrate unit, the operation determination unit 51 determines that the received setting of the stage change work is not adapted. Then, the operation determination unit 51 outputs that the received setting of the stage change work is not adapted to the output unit 32, and notifies it to the worker.

The part operation support device 11 is not able to support the plans that operate the different electronic parts 20A at the same time. The part operation support device 11 is not able to support the work when the electronic parts 20A for stage change are different. When supporting the stage change for a plurality of plans at the same time, the operation determination unit 51 determines whether the operation settings of the electronic parts 20A co-exist in the target plan and whether the target electronic parts 20A are different. For example, the operation determination unit 51 performs the processing of determining an operation system of the electronic part 20A, the processing of determining a type of the electronic part 20A, and the processing of determining whether the electronic part 20A to be mounted is mountable on the mounter device 17 on a plurality of plans. Then, the operation determination unit 51 determines whether the setting of the stage change work is adapted.

The part specification unit 52 performs a processing of specifying an electronic part 20A to be removed from the mounter device 17, a processing of specifying an electronic part 20A to be mounted on the mounter device 17, and a processing of specifying an electronic part 20A to be disassembled, thereby specifying the electronic part 20A for stage change. The part specification unit 52 specifies the electronic part 20A to be supplemented, which can achieve the production plan, among the jigs 20 mounted on the mounter device 17.

### [Processing of specifying electronic part 20A to be removed from mounter device 17]

The processing of specifying an electronic part 20A to be removed (part to be removed) from the mounter device 17 will be described first. The part specification unit 52 performs a processing of specifying a part figure number with producing or production-completed, a processing of specifying a part figure number of a production plan, and a processing of specifying an electronic part 20A to be removed, thereby specifying the part figure number of the electronic part 20A to be removed from the mounter device 17.

### [Processing of specifying part figure number with producing or production-completed]

When the mounter device 17 generates a new substrate unit, the part specification unit 52 specifies a part ID of the new part indicating an electronic part 20A used for the new substrate unit from the plan DB 43.

For example, when notified of an instruction of starting the work of removing the electronic part 20A from the input unit 31, the part specification unit 52 searches the plan DB 43, and determines whether a plan with the state 43H of "producing" is present. When determining that a plan with "producing" is present, the part specification unit 52 acquires the group 43G of the plan with "producing" from the plan DB 43. Further, the part specification unit 52 acquires the unit figure number 43C with the same group as the acquired group 43G and with the state 43H of "producing" or "planning" from the plan DB 43.

In the example illustrated in FIG. 6, the part specification unit 52 acquires the group 43G of "group=A" as the plan with "producing" from the plan DB 43. Then, the part specification unit 52 acquires "unit figure number = U0100" of "UNIT-A" with the same group as the acquired group 43G and with "producing" from the plan DB 43. The part specification unit 52 acquires "unit figure number = U0200" of "UNIT-B" with the same group as the acquired group 43G and with "planning" from the plan DB 43.

Then, the part specification unit 52 acquires the part figure number 44D corresponding to the acquired unit figure number 43C (44B) from the unit figure number DB 44. In the example illustrated in FIG. 7, the part specification unit 52 acquires "part figure number = P1234, P0023, P0412, P0411, P3726" as "unit figure number = U0100" from the unit figure number DB 44. The part specification unit 52 acquires "part figure number = P0023, P0008, P9222, P3345" as "unit figure number = U0200" from the unit figure number DB 44. Further, the part specification unit 52 performs a "processing of specifying a part figure number of a production plan" described later.

On the other hand, when searching the plan DB 43 and determining that a "producing" or "planning" plan is not present, the part specification part 52 determines whether a "production-completed" plan is present. When determining that a "production-completed" plan is present, the part specification unit 52 acquires the group 43G of the last production plan in the "production-completed" plans from the plan DB 43.

Further, the part specification unit 52 acquires the unit figure number 43C with the same group as the acquire group 43G and with the "state" of "producing" from the plan DB 43. Then, the part specification unit 52 acquires the part figure number 44D corresponding to the acquired unit figure number 43C (44B) from the unit figure number DB 44. Subsequently, the part specification unit 52 performs a "processing of specifying a part figure number of a production plan" described later. On the other hand, when determining that a "production-completed" plan is not present, the part specification unit 52 performs the "processing of specifying a part figure number of a production plan" described later.

### [Processing of specifying part figure number of production plan]

When the mounter device 17 generates a new substrate unit, the part specification unit 52 specifies the unit figure number 43C of the present part indicating the electronic part 20A used for the substrate unit being currently produced by the mounter device 17 from the plan DB 43.

For example, the part specification unit 52 acquires the production plan or the planning group 43G from the plan DB 43. Further, the part specification unit 52 acquires the unit figure numbers 43C of all the plans with the same group as the acquired group 43G and with the state 43H of "planning" from the plan DB 43.

In the example illustrated in FIG. 6, the part specification unit 52 acquires "group = A" as the "planning" plan from the plan DB 43. Then, the part specification unit 52 acquires "unit figure number = U0200" of "UNIT-B" with the same group as the acquired group 43G and with "planning" from the plan DB 43.

The part specification unit 52 acquires the part figure number 44D corresponding to the acquired unit figure number 43C (44B) from the unit figure number DB 44. In the example illustrated in FIG. 7, the part specification unit 52 acquires "part figure number = P0023, P0008, P9222, P3345" as "unit figure number = U0200" from the unit figure number DB 44.

### [Processing of specifying electronic part 20A to be removed]

The part specification unit 52 compares the specified part figure numbers of the new parts with the part figure numbers of the present parts, and specifies the electronic parts 20A not included in the new parts among the present parts.

For example, the part specification unit 52 acquires the part figure number 45D with the location 45E of "mounter" from the jig-part combination DB 45. In the example illustrated in FIG. 8, the part specification unit 52 acquires "part figure number = P1234, P0023, P0412, P0411, P3726" as "location = mounter" from the jig-part combination DB 45.

Further, the part specification unit 52 extracts part figure numbers not included in the "producing" or "production-completed" part figure numbers and the "planning" part figure numbers in the part figure numbers 45D with the acquired location 45E of "mounter." In the example illustrated in FIG. 8, the part specification unit 52 extracts "part figure number = P1234, P0412, P0411." That is, the part specification unit 52 extracts "part name = a, c, d" as the electronic parts 20A to be removed from the mounter device 17. Further, the part specification unit 52 notifies the extracted part figure numbers of the electronic parts 20A as the part figure numbers of the electronic parts 20A to be removed from the mounter device 17 to the first display control unit 55.

### [Processing of specifying electronic part 20A to be mounted on mounter device 17]

A processing of specifying an electronic part 20A to be mounted on the mounter device 17 will be described below. The part specification unit 52 performs a processing of specifying a part figure number of an electronic part 20A to be mounted and a processing of determining whether a part figure number of the electronic part 20A to be mounted is in the waiting station 15, and specifies the part figure number of the electronic part 20A to be mounted on the mounter device 17. The processings will be described in the following.

### [Processing of specifying part figure number of electronic part 20A to be mounted]

The part specification unit 52 compares the specified part figure numbers of the new parts with the part figure numbers of the present parts, and specifies the electronic parts 20A not included in the present parts among the new parts. For example, when notified of an instruction of starting the work of mounting the electronic part 20A from the input unit 31, the part specification unit 52 acquires the part figure number with the location 45E of "mounter" from the jig-part combination DB 45. In the example illustrated in FIG. 8, the part specification unit 52 acquires "part figure number = P1234, P0023, P0412, P0411, P3726" as "location = mounter" from the jig-part combination DB 45.

Further, the part specification unit 52 extracts the part figure numbers not included in the part figure numbers of the production plan in the part figure numbers 45D with the acquired location 45E of "mounter." The part specification unit 52 specifies the extracted part figure numbers as the part figure numbers of the "electronic parts to be mounted." In the example illustrated in FIG. 8. The part specification unit 52 extracts "part figure number = P0008, P9222, P3345."

### [Processing of determining whether part figure number of electronic part 20A to be mounted is in waiting station 15]

The part specification unit 52 acquires the part figure number 45D and the part ID 45B with the location 45E of "waiting station" from the jig-part combination DB 45. In the example illustrated in FIG. 8, the part specification unit 52 extracts "part figure number = P0008, P9222, P3345."

The part specification unit 52 determines whether the specified part figure numbers of the "electronic parts to be mounted" are in the acquired part figure numbers 45D with the location 45E of "waiting station." When determining that the specified part figure numbers of the "electronic parts to be mounted" are included in the acquired part figure numbers 45D with the location 45E of "waiting station", the part specification unit 52 notifies the specified part figure numbers of the "electronic parts to be mounted" to the second display control unit 56. In the example illustrated in FIG. 8, the part specification unit 52 notifies "part figure number = P0008, P9222, P3345" to the second display control unit 56.

On the other hand, when determining that the part figure numbers of the "electronic parts to be mounted" are not included in the acquired part figure numbers 45D with the location 45E of "waiting station", the part specification unit 52 determines that the "electronic parts to be mounted" are not prepared in the waiting station 15, and terminates the processing.

### [Processing of specifying electronic part to be disassembled]

A processing of specifying an electronic part 20A to be disassembled will be described below. When the production of the substrate units is ended, the part specification unit 52 specifies the electronic parts 20A to be removed and disassembled from the jigs 20, or the parts to be disassembled. In other words, after the worker finishes the work of mounting the electronic parts 20A, the part specification unit 52 specifies the electronic parts 20A which are not scheduled to be operated in the future production plans, or the parts to be disassembled from the electronic parts 20A removed from among the mounter device 17.

For example, when notified of an instruction of starting the work of disassembling the electronic parts 20A by the worker from the input unit 31, the part specification unit 52 extracts the unit figure number 43C with the state 43H of "planning" from the plan DB 43. Further, the part specification unit 52 specifies the part figure number 44D corresponding to the extracted unit figure number 43C (44B) from the unit figure number DB 44. In the example illustrated in FIG. 6, the part specification unit 52 extracts "unit figure number = U0300, U0400" as "state = planning", and specifies the part figure number 44D corresponding to the extracted unit figure number 44B from the unit figure number DB 44. Herein, for the sake of convenience of explanation, not the part figure number but the part name is used and an explanation will be made assuming "part name = e, n, o, p, q" as "unit figure number = U0300" and "part name = d, s, t, u, v" as "unit figure number = U0400."

Further, the part specification unit 52 determines whether the removed electronic parts 20A are included in the specified part names 44C. When determining that the removed electronic parts 20A are included in the specified part names 44C, the part specification unit 52 determines that the removed electronic parts 20A are to be operated in the future production plans, and does not need to perform a special processing.

On the other hand, when determining that the removed electronic parts 20A are not included in the specified part names 44C, the part specification unit 52 determines that the removed electronic parts 20A are not to be operated in the future production plans, and specifies the removed electronic parts 20A as the electronic parts 20A to be disassembled. Then, the part specification unit 52 extracts the part figure numbers with the location of "waiting station" other than "mounter" from among the part figure numbers of the specified electronic parts 20A to be disassembled, and notifies the extracted part figure numbers to the third display control unit 57. In the example illustrated in FIG. 7, the part specification unit 52 specifies "part name = a, c" among "part name = a, c, d" of the electronic parts 20A removed from the mounter device 17 as the electronic parts 20A to be disassembled. Then, the part specification unit 52 notifies the part figure numbers of the specified electronic parts 20A to be disassembled to the third display control unit 57.

Whenever a predetermined time elapses, the moisture absorption management unit 53 measures an out-of-storage time in which a moisture absorption management part is out of the moisture absorption storage. For example, when the moisture absorption management unit 53 is not able to use the RF antenna 16 in the waiting station 15 to confirm the location of the moisture absorption management part, the moisture absorption management part is taken out of the moisture absorption storage and is determined as being under normal temperature and normal humidity. Then, the moisture absorption management unit 53 measures a time in which the location of the moisture absorption management part is not the waiting station 15, and assumes the measured time as an out-of-storage time. Then, the moisture absorption management unit 53 stores the measured time in the out-of-storage time 46H in the part DB 46.

When notified of the part figure number of the electronic part 20A to be mounted on the mounter device 17 from the part specification unit 52, the moisture absorption management unit 53 determines whether the electronic part 20A corresponding to the part figure number has exceeded the moisture absorption management time. For example, the moisture absorption management unit 53 acquires the moisture absorption management time 46G from the part DB 46, and determines whether the measured out-of-storage time has exceeded the moisture absorption management time 46G.

When the out-of-storage time has not exceeded the moisture absorption management time 46G, the moisture absorption management unit 53 specifies an electronic part 20A which has not exceeded the moisture absorption management time 46G. Then, the moisture absorption management unit 53 associates the part ID 46A of the specified electronic part 20A with the fact that the electronic part 20A has not exceeded the moisture absorption management time 46G and notifies them to the second display control unit 56. On the other hand, when the out-of-storage time has exceeded the moisture absorption management time 46G, the moisture absorption management unit 53 specifies an electronic part 20A which has exceeded the moisture absorption management time 46G. The moisture absorption management unit 53 associates the part ID 46A of the specified electronic part 20A with the fact that the electronic part 20A has exceeded the moisture absorption management time 46G, and notifies them to the second display control unit 56.

In the example illustrated in FIG. 9, since the out-of-storage time 46H with "part ID = T000012" is "000:10:12", the moisture absorption management unit 53 determines that the moisture absorption management time 46G has not exceeded "166:00:00." Similarly, since the out-of-storage time 46H with "part ID = T005689" is "054:01:00", the moisture absorption management unit 53 determines that the moisture absorption management time 46G has not exceeded "166:00:00." Then, the moisture absorption management unit 53 notifies, to the second display control unit 56, that the out-of-storage time 46H with "part ID = T000012, T005689" has not exceeded the moisture absorption management time 46G.

The supplement determination unit 54 determines whether the total remaining count (the total number) of electronic parts 20A in the jigs 20 mounted at the respective mount positions in a plurality of mount positions in the mounter device 17 is less than the number requested to achieve the production plan.

With reference to the production count 43D in the plan DB 43 and the mount count 44F in the unit figure number DB 44, the supplement determination unit 54 calculates the number of requested electronic parts 20A based on (the mount number * the production number) of the electronic parts 20A per selected production plan. Further, the supplement determination unit 54 sums all the requested numbers calculated per production plan, and calculates the number requested to achieve the plan of (the number requested to achieve plans = the number requested to achieve plan 1 + the number requested to achieve plan 2 + ···) for the electronic parts 20A used for the production plans.

After calculating the number of electronic parts 20A requested to achieve the plan, the supplement determination unit 54 calculates the total remaining count of the remaining count 46I corresponding to the part ID 46A with the location of the mounter device 17 per part figure number 44D of the electronic part 20A.

The first display control unit 55 specifies the jig 20 which is attached with the present part specified by the part specification unit 52, and emits the LED 20E of the RF tag 20C of the specified jig 20. In other words, the first display control unit 55 performs a processing of acquiring a jig ID corresponding to the part figure number of the electronic part 20A to be removed, a processing of acquiring a RF tag ID corresponding to the acquired jig ID, and a processing of transmitting a command based on the acquired RF tag ID. Then, the first display control unit 55 performs the processing of transmitting a command based on the RF tag ID thereby to emit the LED 20E of the RF tag 20C of the jig 20. The processings will be sequentially described below.

### [Processing of acquiring jig ID corresponding to part figure number of electronic part 20A to be removed]

When notified of the part figure number 45D of the electronic part 20A to be removed from the mounter device 17 from the part specification unit 52, the first display control unit 55 acquires the jig ID 45A of the jig 20 mounting the electronic part 20A to be removed from the mounter device 17 from the jig-part combination DB 45.

For example, the first display control unit 55 acquires the jig ID 45A corresponding to the part figure number 45D specified by the part specification unit 52 from the jig-part combination DB 45. In the example illustrated in FIG. 8, the first display control unit 55 acquires "jig ID = C0111, C2248, C0365" corresponding to "part figure number = P1234, P0412, P0411."

### [Processing of acquiring RF tag ID corresponding to acquired jig ID]

The first display control unit 55 specifies the RF tag 20C attached on the specified jig 20 of the present part. For example, the first display control unit 55 acquires the RF tag ID 47D corresponding to the acquired jig ID 47A from the jig-RF tag combination DB 47. In the example illustrated in FIG. 10, the first display control unit 55 acquires "RF tag ID = RF2625, RF0312, RF7001" corresponding to "jig ID = C0111, C2248, C0365."

### [Processing of transmitting command based on acquired RF tag ID]

The first display control unit 55 transmits a command based on the acquired RF tag ID and the antenna ID of the RF antenna with the location corresponding to the RF tag ID. For example, the first display control unit 55 acquires the location 45E corresponding to the jig ID 45A corresponding to the RF tag ID 47D from the jig-part combination DB 45. Further, the first display control unit 55 acquires the antenna ID 48A corresponding to the acquired location 48B from the RF antenna DB 48. The first display control unit 55 acquires the antenna ID 48A with the location 48B of "mounter" from the RF antenna DB 48, and transmits a command based on the acquired RF tag ID and antenna ID.

In the example illustrated in FIG. 11, the first display control unit 55 acquires "antenna ID = ANT4" with the location 48B of "mounter 1" from the RF antenna DB 48. Then, the first display control unit 55 transmits a command to the RF tag 20C of each jig 20 based on the acquired "antenna ID = ANT4" and "RF tag ID = RF2625, RF0312, RF7001." Then, the RF tag 20C of the jig 20 for the electronic part 20A to be removed or the part to be removed emits the LED 20E in response to the command.

Further, the first display control unit 55 receives information associating the RF tag ID with the antenna ID therein from the communication interface 33. The first display control unit 55 specifies where the RF antennas 16 and 18 are located based on the received antenna IDs.

The first display control unit 55 specifies the corresponding jig ID 47A from the RF tag ID 47D, and specifies the location 45E of the specified jig ID 47A (45A) from the jig-part combination DB 45. The first display control unit 55 specifies the RF antennas 16 and 18 corresponding to the locations 45E (48B) from the RF antenna DB 48. Then, the first display control unit 55 stores the specified location of the jig 20 in the jig-part combination DB 45. Consequently, the jig-part combination DB 45 is able to update the locations of the electronic parts 20A to the latest information, and to store the same therein.

After the jig 20 of which LED 20E is emitted by the first display control unit 55 is removed from the mounter device 17, the second display control unit 56 specifies a jig 20 for the specified new part or the electronic part 20A to be mounted, and emits the LED 20E of the specified jig 20. In other words, the second display control unit 56 performs a processing of acquiring a jig ID corresponding to a part figure number of an electronic part 20A to be mounted, a processing of acquiring a RF tag ID corresponding to the acquired jig ID, and a processing of transmitting a command based on the acquired RF tag ID. Then, the second display control unit 56 emits the LED 20E of the RF tag 20C of the jig 20 mounting the electronic part 20A to be mounted in response to the transmitted command based on the acquired RF tag ID. The processings will be sequentially described in the following.

### [Processing of acquiring jig ID corresponding to part figure number of electronic part 20A to be mounted]

For example, when notified the part figure number 45D of the electronic part 20A to be mounted on the mounter device 17 from the part specification unit 52, the second display control unit 56 specifies the jig ID 45A of the jig 20 mounting the electronic part 20A to be mounted on the mounter device 17 from the jig-part combination DB 45. In the example illustrated in FIG. 8, the second display control unit 56 acquires "jig ID = C1234, C0011, C5102" corresponding to "part figure number = P0008, P9222, P3345."

The second display control unit 56 specifies a jig 20 of a new part for which an elapsed time after the shipment from the waiting station 15 storing the electronic parts 20A is less than a predetermined value, among the specified new parts. In other words, the second display control unit 56 extracts a part ID for which the moisture absorption management time notified from the moisture absorption management unit 53 is not exceeded from among the acquired part IDs. An explanation will be made assuming that a notification that the moisture absorption management time is not exceeded is received from the moisture absorption management unit 53.

### [Processing of acquiring RF tag ID corresponding to acquired jig ID]

The second display control unit 56 specifies the RF tag 20C of the jig 20 mounting the specified new part. For example, the second display control unit 56 acquires the RF tag ID 47D of the RF tag 20C corresponding to the jig ID 47A of the specified jig 20 from the jig-RF tag combination DB 47. In the example illustrated in FIG. 10, the second display control unit 56 acquires "RF tag ID = RF0001, RF0127, RF3389" corresponding to "jig ID = C1234, C0011, C5102."

### [Processing of transmitting command based on acquired RF tag ID]

The second display control unit 56 transmits a command based on the acquired RF tag ID and the antenna ID of the RF antenna with the location corresponding to the RF tag ID. For example, the second display control unit 56 acquires the location 45E corresponding to the jig ID 45A corresponding to the RF tag ID 47D from the jig-part combination DB 45. Further, the second display control unit 56 acquires the antenna ID 48A corresponding to the acquired location 48B from the RF antenna DB 48. The second display control unit 56 acquires the antenna ID 48A with the location 48B of "waiting station" from the RF antenna DB 48, and transmits a command based on the acquired RF tag ID and antenna ID.

In the example illustrated in FIG. 11, the second display control unit 56 acquires "antenna ID = ANT1" with the location 48B of "waiting station 1" from the RF antenna DB 48. The second display control unit 56 transmits a command to the RF tag 20C of each jig 20 based on the acquired "antenna ID = ANT1" and "RF tag ID = RF0001, RF0127, RF3389." Then, the RF tag 20C of the jig 20 for the electronic part 20A to be mounted emits the LED 20E in response to the command.

When receiving a notification that the out-of-storage time of the moisture absorption management part has exceeded the moisture absorption management time from the moisture absorption management unit 53, the second display control unit 56 may blink the LED 20E of the RF tag 20C of the jig 20 mounting the notified moisture absorption management part. For example, the second display control unit 56 acquires the jig ID 45A and the part ID 45B corresponding to the part figure number 45D specified by the part specification unit 52 from the jig-part combination DB 45.

Then, the second display control unit 56 extracts the part ID for which the moisture absorption management time notified from the moisture absorption management unit 53 is exceeded from among the acquired part IDs 45B. Further, the second display control unit 56 acquires the RF tag ID 47D corresponding to the acquired jig ID 45A (47A) from the jig-RF tag combination DB 47. The second display control unit 56 acquires the antenna ID 48A with the location 48B of "waiting station" from the RF antenna DB 48. Then, the second display control unit 56 transmits a command based on the acquired antenna ID 48A and RF tag ID. Consequently, the second display control unit 56 blinks the LED 20E of the jig 20 with the RF tag 20C corresponding to the RF tag ID.

When the production plan of the substrate units is terminated, the third display control unit 57 specifies a jig 20 of an electronic part 20A to be removed and disassembled from the jig 20, and emits the LED 20E of the RF tag 20C of the specified jig 20. In other words, when notified the part figure number of the electronic part 20A to be disassembled from the part specification unit 52, the third display control unit 57 specifies the jig 20 for the electronic part 20A to be disassembled and transmits a command to the RF tag 20C of the specified jig 20.

For example, the third display control unit 57 acquires the jig ID 45A corresponding to the part figure number 45D specified by the part specification unit 52 from the jig-part combination DB 45. In the example illustrated in FIG. 8, the third display control unit 57 acquires "jig ID = C0111, C2248" corresponding to "part figure number = P1234, P0412."

Further, the third display control unit 57 acquires the RF tag ID 47D corresponding to the acquired jig ID 45A (47A) from the jig-RF tag combination DB 47. In the example illustrated in FIG. 10, the third display control unit 57 acquires "RF tag ID = RF2625, RF0312" corresponding to "jig ID = C0111, C2248."

The third display control unit 57 acquires the antenna ID 48A with the location 48B of "waiting station" from the RF antenna DB 48. Then, the third display control unit 57 transmits a command based on the acquired antenna ID 48A and RF tag ID. For example, the third display control unit 57 acquires the location 45E of the jig ID 45A corresponding to the RF tag ID 47D from the jig-part combination DB 45. Further, the third display control unit 57 acquires the antenna ID 48A corresponding to the acquired location 48B from the RF antenna DB 48. The third display control unit 57 acquires the antenna ID 48A with the location 48B of "mounter" from the RF antenna DB 48, and transmits a command based on the acquired RF tag ID and antenna ID. In the example illustrated in FIG. 11, the third display control unit 57 acquires "antenna ID = ANT1" with the location 48B of "waiting station 1" from the RF antenna DB 48. The third display control unit 57 transmits a command to the RF tag 20C of each jig 20 based on the acquired "antenna ID = ANT1" and "RF tag ID = RF2625, RF0312." Then, the RF tag 20C of the jig 20 for the electronic part 20A to be disassembled or the part to be disassembled emits the LED 20E in response to the command.

When notified of the fact that the number of remaining electronic parts 20A is less than the number requested to achieve the plan from the supplement determination unit 54, the fourth display control unit 58 specifies a jig 20 mounting the electronic part 20A to be supplemented among the jigs 20 which are not mounted at the mount positions. The fourth display control unit 58 emits the LED 20E of the RF tag 20C of the specified jig 20. In other words, the fourth display control unit 58 performs a processing of acquiring a jig ID corresponding to a part figure number of an electronic part 20A to be supplemented, and a processing of specifying a RF tag ID corresponding to the acquired jig ID. Further, the fourth display control unit 58 performs a processing of transmitting a command based on the acquired RF tag ID thereby to emit the LED 20E of the jig 20 for the part to be supplemented. The processings will be sequentially described in the following.

### [Processing of acquiring jig ID corresponding to part figure number of electronic part 20A to be supplemented]

For example, when notified of the part figure number 45D of the electronic part 20A to be supplemented from the part specification unit 52, the fourth display control unit 58 specifies the jig ID 45A of the jig 20 mounting the electronic part 20A to be supplemented, which is to be mounted on the mounter device 17, from the jig-part combination DB 45. In the example illustrated in FIG. 8, the fourth display control unit 58 specifies "jig ID = C1234, C0011, C5102" corresponding to "part figure number = P0008, P9222, P3345."

The fourth display control unit 58 specifies a jig 20 mounting the electronic part 20A to be supplemented for which an elapsed time after the shipment from the waiting station 15 storing the electronic parts 20A to be supplemented is less than a predetermined value. In other words, the fourth display control unit 58 extracts a part ID for which the moisture absorption management time notified from the moisture absorption management unit 53 is not exceeded, from among the acquired part IDs. An explanation will be made assuming that a notification that the moisture absorption management time is not exceeded is received from the moisture absorption management unit 53.

### [Processing of specifying RF tag ID corresponding to specified jig ID]

The fourth display control unit 58 specifies the RF tag 20C of the specified jig 20 mounting the electronic part 20A to be supplemented. For example, the fourth display control unit 58 specifies the RF tag ID 47D of the RF tag 20C corresponding to the jig ID 47A of the specified jig 20 from the jig-RF tag combination DB 47. In the example illustrated in FIG. 10, the fourth display control unit 58 specifies "RF tag ID = RF00001, RF0127, RF3389" corresponding to "jig ID = C1234, C0011, C5102."

### [Processing of transmitting command based on specified RF tag ID]

The fourth display control unit 58 transmits a command based on the acquired RF tag ID, and the antenna ID of the RF antenna with the location corresponding to the RF tag ID. For example, the fourth display control unit 58 acquires the location 45E with the jig ID 45A corresponding to the RF tag ID 47D from the jig-part combination DB 45. Further, the fourth display control unit 58 acquires the antenna ID 48A corresponding to the acquired location 48B from the RF antenna DB 48. The fourth display control unit 58 acquires the antenna ID 48A with the location 48B of "mounter" from the RF antenna DB 48, and transmits a command based on the acquired RF tag ID and antenna ID.

In the example illustrated in FIG. 11, the fourth display control unit 58 acquires "antenna ID = ANT1" with the location 48B of "waiting station 1" from the RF antenna DB 48. Then, the fourth display control unit 58 transmits a command to the RF tag 20C of each jig 20 based on the acquired "antenna ID = ANT1" and "RF tag ID = RF 0001, RF0127, RF3389." Then, the RF tag 20C of the jig 20 for the electronic part 20A to be supplemented or the part to be supplemented emits the LED 20E in response to the command.

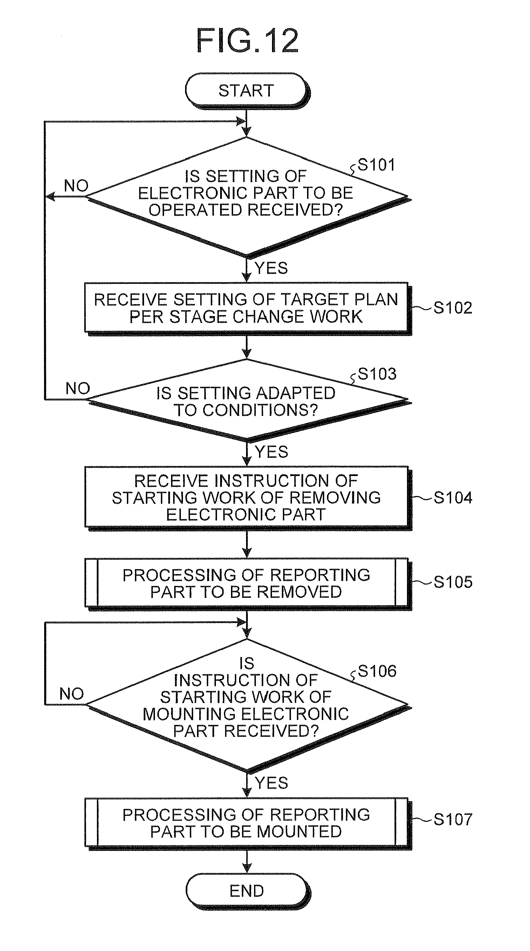

The operations of the part operation support device 11 will be described below with reference to FIG. 12. FIG. 12 is a flowchart illustrating exemplary operations of the control unit 35 for the stage change support processing.

When receiving a setting of an electronic part 20A to be operated via the input unit 31 (Yes in step S101), the control unit 35 in the part operation support device 11 receives a setting of a target plan per stage change work from the worker via the input unit 31 (step S102). The operation determination unit 51 in the control unit 35 determines whether the received setting is adapted to the conditions (step S103). When determining that the received setting is adapted to the conditions (Yes in step S103), the operation determination unit 51 receives an instruction of starting the work of removing the electronic part 20A via the input unit 31 (step S104). On the other hand, when determining that the received setting is not adapted to the conditions (No in step S103), the operation determination unit 51 proceeds to step S101 to receive a new part operation setting. In this case, the part operation support device 11 may output that the setting is not adapted to the conditions from the output unit 32.

Further, the control unit 35 performs a processing of reporting an electronic part 20A to be removed or a part to be removed (step S105). Further, after performing the processing of reporting a part to be removed, the control unit 35 determines whether it has received an instruction of starting the work of mounting the electronic part 20A from the worker via the input unit 31 (step S106). When determining that the control unit 35 has received an instruction of starting the work of mounting the electronic part 20A from the worker (Yes in step S106), the control unit 35 performs a processing of reporting the electronic part 20A to be mounted or the part to be mounted (step S107), and terminates the processing operations illustrated in FIG. 12. On the other hand, when determining that the control unit 35 has not received an instruction of starting the work of mounting the electronic part 20A from the worker (No in step S106), the control unit 35 does not perform a processing until it receives an instruction of starting the work of mounting the electronic part 20A from the worker.

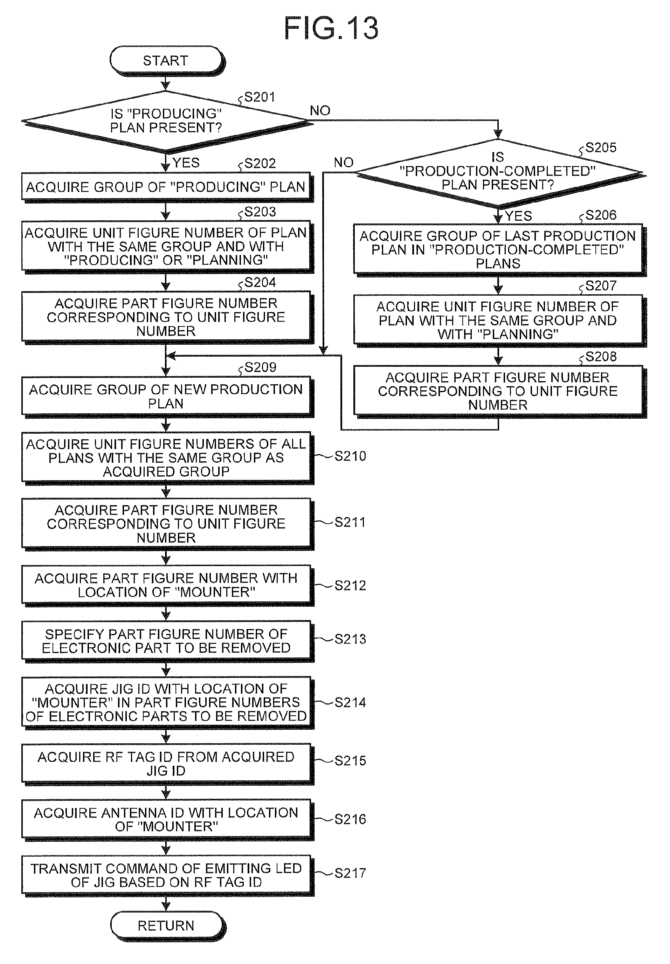

FIG. 13 is a flowchart illustrating exemplary processing operations of the control unit 35 for a processing of reporting a part to be removed. The processings correspond to step S105 illustrated in FIG. 12.

The part specification unit 52 in the control unit 35 determines whether a "producing" plan is present (step S201). When determining that a "producing" plan is present (Yes in step S201), the part specification unit 52 acquires the group 43G of the "producing" plan from the plan DB 43 (step S202). Further, the part specification unit 52 acquires the unit figure number 43C of the plan with the same group as the acquired group 43G and with the state 43H of "producing" or "planning" from the plan DB 43 (step S203). Then, the part specification unit 52 acquires the part figure number 44D corresponding to the unit figure number 43C (44B) acquired in step S203 from the unit figure number DB 44 (step S204).

On the other hand, when determining that a "producing" plan is not present (No in step S201), the part specification unit 52 determines whether a "production-completed" plan is present (step S205). When determining that a "production-completed" plan is present (Yes in step S205), the part specification unit 52 acquires the group 43G of the last production plan in the "production-completed" plans from the plan DB 43 (step S206). Further, the part specification unit 52 acquires the unit figure number 43C of the plan with the same group as the acquired group 43G and with the state 43H of "planning" from the plan DB 43 (step S207). Then, the part specification unit 52 acquires the part figure number 44D corresponding to the unit figure number 43C (44B) acquired in step S207 from the unit figure number DB 44 (step S208). On the other hand, when determining that a "production-completed" plan is not present (No in step S205), the part specification unit 52 proceeds to step S209.

The part specification unit 52 acquires the group 43G of a new production plan from the plan DB 43 (step S209). Further, the part specification unit 52 acquires the unit figure numbers 43C of all the plans with the same group as the acquired group 43G from the plan DB 43 (step S210). Then, the part specification unit 52 acquires the part figure number 44D corresponding to the unit figure number 43C (44B) acquired in step S210 from the unit figure number DB 44 (step S211).

The part specification unit 52 acquires the part figure number 45D with the location 45E of "mounter" from the jig-part combination DB 45 (step S212). Further, the part specification unit 52 specifies the part figure number 45D of the electronic part 20A to be removed. That is, the part specification unit 52 extracts the part figure numbers other than the part figure numbers acquired in steps S204, S208, S209 from the part figure numbers 45D acquired in step S212 (step S213).

The first display control unit 55 acquires the jig ID 45A with the location 45E of "mounter" from the part figure numbers 45D of the electronic parts 20A to be removed which are specified in step S213 (step S214). Further, the first display control unit 55 acquires the RF tag ID 47D corresponding to the jig ID 45A (47A) acquired in step S214 from the jig-RF tag combination DB 47 (step S215). Further, the first display control unit 55 acquires the antenna ID 48A with the location 48B of "mounter" from the RF antenna DB 48 (step S216). Then, the first display control unit 55 transmits a command to the RF tag 20C of the jig 20 for the electronic part 20A to be removed based on the acquired antenna ID 48A and RF tag ID (step S217). The RF tag 20C of the jig 20 for the electronic part 20A to be removed emits the LED 20E in response to the command.

In the processing procedure of the control unit 35, the processings in step S201 to step S208 and the processings in step S209 to step S211 are exchangeable in their orders and may be performed at the same time.

In the processings illustrated in FIG. 13, when a jig 20 for a part to be removed is present in the jigs 20 being mounted on the mounter device 17, the LED 20E of the RF tag 20C of the jig 20 for the part to be removed is emitted. Consequently, the worker is able to easily identify the jig 20 for the part to be removed from the jigs 20 being mounted on the mounter device 17.

### [Processing of reporting electronic part to be mounted]

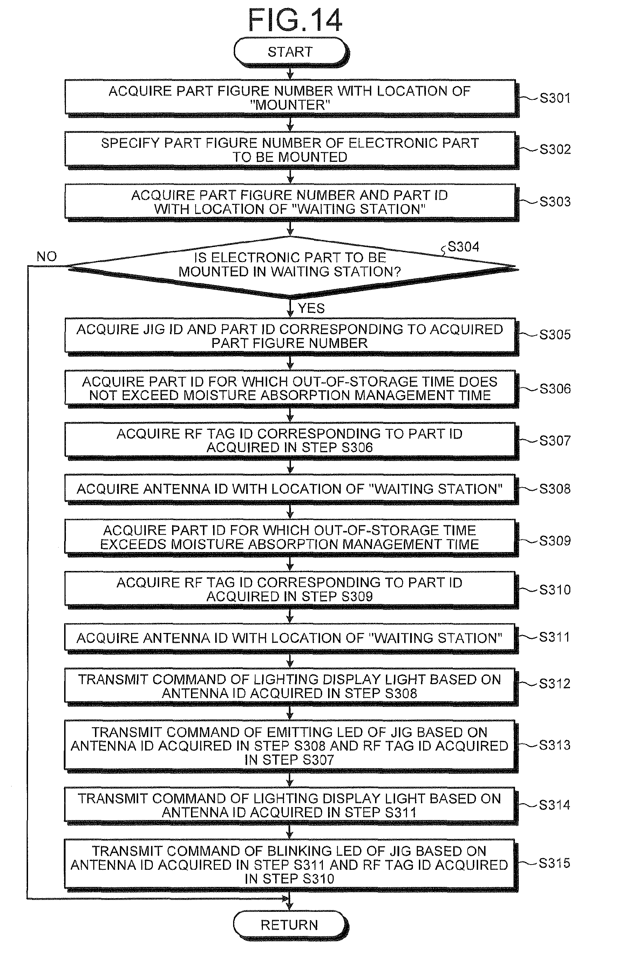

FIG. 14 is a flowchart illustrating exemplary processing operations of the control unit 35 for a processing of reporting a part to be mounted. The processings correspond to the processing in step S107 illustrated in FIG. 12.

The part specification unit 52 in the control unit 35 acquires the part figure number 45D with the location 45E of "mounter" from the jig-part combination DB 45 (step S301). Further, the part specification unit 52 specifies the part figure number 45D of the electronic part 20A to be mounted. That is, the part specification unit 52 extracts part figure numbers not present in the part figure numbers acquired in step S211 among the acquired part figure numbers 45D (step S302). The part specification unit 52 acquires the part ID 45B of the part figure number 45D with the location 45E of "waiting station" from the jig-part combination DB 45 (step S303).

The part specification unit 52 determines whether the electronic part 20A to be mounted is in the waiting station 15 (step S304). That is, the part specification unit 52 determines whether the part figure number specified in step S302 is present in the part figure numbers 45D acquired in step S303. When the part specification unit 52 determines that the part figure number selected in step S302 is present in the part figure numbers acquired in step S303 (Yes in step S304), the second display control unit 56 performs the processing in step S305. That is, the second display control unit 56 acquires the jig ID 45A and the part ID 45B corresponding to the part figure number 45D acquired in step S303 from the jig-part combination DB 45 (step S305). On the other hand, when determining that the part figure number selected in step S302 is not present in the part figure numbers 45D acquired in step S303 (No in step S304), the part specification unit 52 determines that the electronic part 20A to be mounted is not prepared in the waiting station 15. Then, the part specification unit 52 terminates the processing operations illustrated in FIG. 14.

The moisture absorption management unit 53 acquires the part ID 46A for which the out-of-storage time does not exceed the moisture absorption management time from the part DB 46 (step S306). Further, the second display control unit 56 acquires the RF tag ID corresponding to the part ID 46A acquired in step S306 (step S307). That is, the second display control unit 56 acquires the jig ID 45A corresponding to the part ID 46A (45B) acquired in step S306 from the jig-part combination DB 45. Further, the second display control unit 56 acquires the RF tag ID 47D corresponding to the acquired jig ID 45A (47A) from the jig-RF tag combination DB 47. The second display control unit 56 acquires the antenna ID 48A with the location 48B of "waiting station" from the RF antenna DB 48 (step S308).

The moisture absorption management unit 53 acquires the part ID 46 for which the out-of-storage time exceeds the moisture absorption management time from the part DB 46 (step S309). Further, the second display control unit 56 acquires the RF tag ID 47D corresponding to the jig ID 45A (47A) with the part ID 46A (45B) acquired in step S309 from the jig-RF tag combination DB 47 (step S310). The second display control unit 56 acquires the jig ID 45A corresponding to the part ID 45B acquired in step S309 from the jig-part combination DB 45. Further, the second display control unit 56 acquires the RF tag ID 47D corresponding to the acquired jig ID 47A from the jig-RF tag combination DB 47. The second display control unit 56 acquires the antenna ID 48A with the location 48B of "waiting station" from the RF antenna DB 48 (step S311).

The second display control unit 56 transmits a command of lighting the display light 15A of the relevant waiting station 15 based on the antenna ID 48A acquired in step S308 (step S312). The display light 15A of the waiting station 15 is lit in response to the command. Consequently, the worker is able to identify the waiting station 15 in which the jig 20 for the electronic part 20A to be mounted is stored in response to the lighting of the display light 15A.

Further, the second display control unit 56 transmits a command to the RF tag 20C of the jig 20 for the part to be mounted for which the moisture absorption management is not exceeded, based on the antenna ID 48A acquired in step S308 and the RF tag ID acquired in step S307 (step S313). The RF tag 20C of the jig 20 for the part to be mounted emits the LED 20E in response to the command. Consequently, the worker is able to identify the jig 20 for the electronic part 20A to be mounted for which the moisture absorption management time is not exceeded in response to the light emission of the LED 20E.

Further, the second display control unit 56 transmits a command of lighting the display light 15A of the relevant waiting station 15 based on the antenna ID 48A acquired in step S311 (step S314). The display light 15A of the waiting station 15 is lit in response to the command. Consequently, the worker is able to identify the waiting station 15 in which the jig 20 for the electronic part 20A to be mounted is stored in response to the lighting of the display light 15A.

Further, the second display control unit 56 transmits a command to the RF tag 20C of the jig 20 for the part to be mounted for which the moisture absorption management time is exceeded, based on the antenna ID 48A acquired in step S311 and the RF tag ID acquired in step S310 (step S315). The RF tag 20C of the jig 20 for the part to be mounted for which the moisture absorption management time is exceeded blinks the LED 20E in response to the command. Consequently, the worker is able to identify the jig 20 for the electronic part 20A to be mounted for which the moisture absorption management time is exceeded in response to the blinking of the LED 20E.

In the processing procedure of the control unit 35, the processings in step S306 to step S308 and the processings in step S309 to step S311 are exchangeable in their orders, and may be performed at the same time. The processings in step S312 and step S313 are exchangeable in their orders, and may be performed at the same time. The processings in step S314 and step S315 are exchangeable in their orders, and may be performed at the same time. The processings in step S313 and step S315 are exchangeable in their orders, and may be performed at the same time.

In the processings illustrated in FIG. 14, when a jig 20 for a part to be mounted for which the moisture absorption management time is not exceeded is present in the waiting station 15, for example, the LED 20E of the RF tag 20C of the jig 20 for the part to be mounted is emitted. Consequently, the worker is able to easily identify the jig 20 for the part to be mounted for which the moisture absorption management time is not exceeded.

In the processings illustrated in FIG. 14, when a jig 20 for a part to be mounted for which the moisture absorption management time is exceeded is present in the waiting station 15, for example, the LED 20E of the RF tag 20C of the jig 20 for the part to be mounted is blinked. Consequently, the worker is able to easily identify the jig 20 for the part to be mounted for which the moisture absorption management time is exceeded.

In the processings illustrated in FIG. 14, when a jig 20 for a part to be mounted is present in the waiting station 15, the display light 15A of the waiting station 15 is lit. Consequently, the worker is able to easily identify the waiting station 15 in which the jig 20 for the part to be mounted is present.

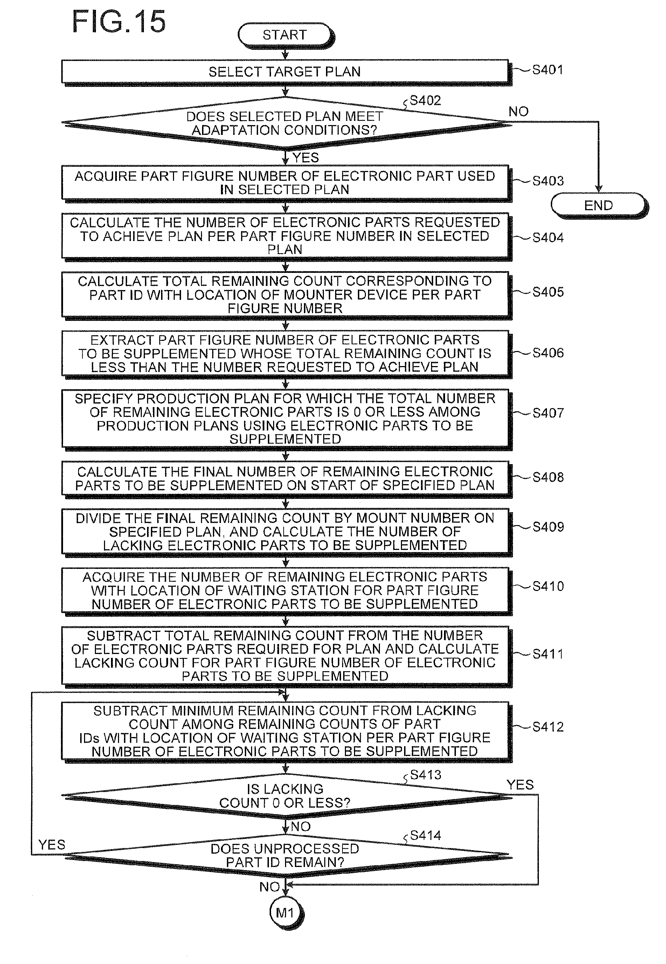

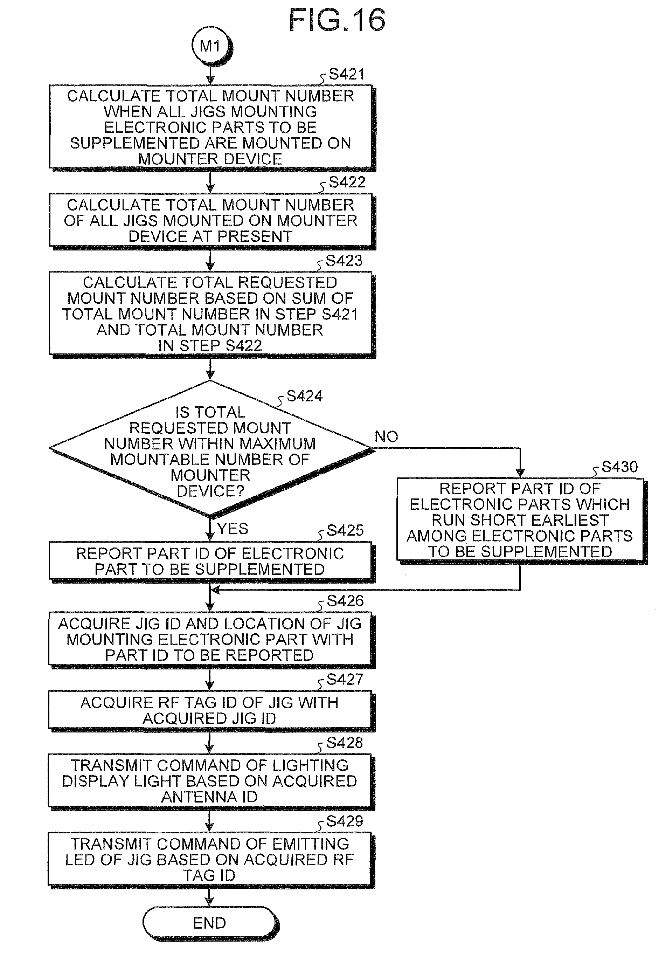

Then, the part operation support device 11 predicts the shortage of the electronic parts 20A requested to achieve the production plan of the substrate units in the jigs 20 mounted in the mounter device 17, in order to prevent the equipment from being stopped due to the shortage of the parts after the stage change work. Then, the part operation support device 11 reports, to the worker, the jig 20 mounting the electronic part 20A to be supplemented of which shortage is predicted. FIGS. 15 and 16 are flowcharts illustrating exemplary processing operations of the control unit 35 for the processing of reporting a part to be supplemented.

In FIG. 15, the control unit 35 selects a target production plan in the production plans of the substrate units by the worker via the input unit 31 (step S401). When a target production plan is selected, the control unit 35 determines whether the adaptation conditions of the target production plan are met with reference to the plan order 43A and the state 43H in the plan DB 43 (step S402). The adaptation conditions are that the target production plan is a "producing" or "planning" plan, the state is "producing" or "planning", and the plan order is subsequent to the previous production-completed plan.

When the adaptation conditions of the target production plan are met (Yes in step S402), the part specification unit 52 in the control unit 35 acquires the part figure number 44D of the electronic part 20A used for the substrate unit in the selected production plan from the unit figure number DB 44 (step S403).

When the part figure number 44D of the electronic part 20A is acquired, the supplement determination unit 54 in the control unit 35 calculates the number of electronic parts 20A requested to achieve the plan per part figure number 44D of the selected production plan (step S404).

The supplement determination unit 54 calculates the number of requested electronic parts 20A based on (the mount number * the production number) of the electronic parts 20A per selected production plan with reference to the production count 43D in the plan DB 43 and the mount count 44F in the unit figure number DB 44. Further, the supplement determination unit 54 sums all the requested numbers calculated per production plan, and calculates the number of requested electronic parts 20A used for the production plans of "the number requested to achieve plans = the number requested to achieve plan 1 + the number requested to achieve plan 2 + ···).

After calculating the number of electronic parts 20A requested to achieve the plans per part figure number 44D, the supplement determination unit 54 calculates the total remaining count of the remaining count 46I corresponding to the part ID 46A with the location of the mounter device 17 per part figure number 44D (step S405). The supplement determination unit 54 acquires the part ID 45B with the location 45E of "mounter" in the part figure numbers 44D (45D) from the jig-part combination DB 45. Further, the supplement determination unit 54 acquires the remaining count 46I corresponding to the part ID 45B (46A) from the part DB 46, and calculates the total number of remaining electronic parts 20A with the location of the mounter device 17 based on the acquired remaining count 46I.

The supplement determination unit 54 extracts the part figure number of the electronic part 20A to be supplemented for which the total remaining count calculated in step S405 is less than the number requested to achieve the plans calculated in step S404, per electronic part 20A with the location of the mounter device 17 (step S406). That is, the supplement determination unit 54 specifies the electronic parts 20A to be supplemented which run short in the target production plan.

When the part figure number of the electronic part 20A to be supplemented is extracted, the supplement determination unit 54 specifies a production plan for which the total number of remaining electronic parts 20A is 0 or less in the production plans using the electronic parts 20A to be supplemented (step S407). The supplement determination unit 54 sequentially subtracts the number of electronic parts 20A requested to achieve the plan from the total number of remaining electronic parts 20A to be supplemented in order of plan, and specifies a production plan for which the total remaining number is 0 or less or the parts run short.

When the production plan for which the total number of remaining electronic parts 20A is 0 or less, the supplement determination unit 54 calculates the final number of remaining electronic parts 20A to be supplemented on the start of the specified plan (step S408). The supplement determination unit 54 subtracts the requested number until the production plan for which the electronic parts 20A to be supplemented run short from the total remaining count, such as (the final remaining count = the total remaining count - the number requested to achieve plan 1 - the number requested to achieve plan 2 - ···), thereby to calculate the final number of remaining electronic parts 20A to be supplemented.

When the final number of remaining electronic parts 20A to be supplemented is calculated, the supplement determination unit 54 divides the final remaining count by the mount count 44F on the specified plan, thereby to calculate the number of lacking electronic parts 20A to be supplemented (step S409). The supplement determination unit 54 acquires the mount count 44F corresponding to the part figure number 44D of the electronic part 20A to be supplemented from the unit figure number DB 44. Then, the supplement determination unit 54 calculates the number of lacking parts on plan 3 based on the mount count 44F with final remaining count ÷ plan 3.

When the number of lacking electronic parts 20A to be supplemented is calculated, the supplement determination unit 54 acquires the number of remaining electronic parts 20A with the location of the waiting station 15 corresponding to the part figure number of the electronic part 20A to be supplemented (step S410). The supplement determination unit 54 acquires the part figure number 45D with the location 45E of the waiting station 15 in the part figure numbers 45D of the electronic parts 20A to be supplemented from the jig-part combination DB 45. When the part figure number 45D is acquired, the supplement determination unit 54 acquires the remaining count 46I corresponding to the part figure number 45D of the electronic part 20A to be supplemented from the part DB 46.

The supplement determination unit 54 subtracts the total remaining count from the number of electronic parts 20A requested to achieve the plan corresponding to the part figure numbers 45D of the electronic parts 20A to be supplemented thereby to calculate the number of lacking electronic parts 20A (step S411).

The supplement determination unit 54 subtracts the minimum remaining count in the remaining counts 46I with the part ID 46A with the location of the waiting station 15 per part figure number 45D (46C) of the electronic part 20A to be supplemented from the lacking count (step S412). The supplement determination unit 54 acquires the part figure number 45D with the location 45E of the waiting station 15 in the part figure numbers 45D of the electronic parts 20A to be supplemented from the jig-part combination DB 45. Further, the supplement determination unit 54 acquires the remaining count 46I with the part ID 46A corresponding to the acquired part figure number 45D (46C) from the part DB 46. Furthermore, the supplement determination unit 54 selects the minimum remaining count from the remaining counts 46I with the acquired part ID 46A, and subtracts the selected minimum remaining count from the lacking count. The supplement determination unit 54 stores the jig ID of the jig 20 mounting the part to be supplemented with the part ID used for the subtraction in the storage unit 34.

The supplement determination unit 54 determines whether the lacking count as a result of the subtraction in step S412 is 0 or less (step S413). When the lacking count is not 0 or less (No in step S413), the supplement determination unit 54 determines whether a part ID 46A unprocessed in step S412 remains (step S414). The number of remaining part IDs unprocessed in step S412 is the remaining count 46I with the part ID 46A which is not subtracted from the lacking count in step S412 among the minimum remaining counts 46I with the part ID 46A in the waiting station 15.

When an unprocessed part ID remains (Yes in step S414), the supplement determination unit 54 proceeds to step S412 to select the remaining count of unprocessed part IDs 46A in the minimum remaining counts 46I with the part ID 46A in the waiting station 15 and to subtract it from the lacking count. When the lacking count is 0 or less (Yes in step S413), the supplement determination unit 54 proceeds to M1 illustrated in FIG. 16. The supplement determination unit 54 calculates the total mount number when all the jigs 20 for the electronic parts 20A to be supplemented are mounted on the mounter device 17, based on the tape widths and the tape pitches with the part IDs of the electronic parts 20A to be supplemented in the waiting station 15 (step S421). The supplement determination unit 54 acquires the tape widths 46D and the tape pitches 46E of all the part IDs 46A of the electronic parts 20A to be supplemented in the waiting station 15 from the part DB 46. Further, the supplement determination unit 54 acquires the occupied mount count 41C corresponding to the tape width 41A and the tape pitch 41B from the cassette condition DB 41 per electronic part 20A to be supplemented in the waiting station 15. Then, the supplement determination unit 54 calculates the total mount number based on a total of the occupied mount counts of the jigs 20 for the electronic parts 20A in the waiting station 15.

Further, the supplement determination unit 54 calculates the total mount number of all the jigs 20 mounted on the mounter device 17 at present based on the tape width and the tape pitch of the part ID of the electronic part 20A in the mounter device 17 (step S422).

The supplement determination unit 54 calculates the total requested mount number based on the sum of the total mount number calculated in step S421 and the total mount number calculated in step S422 (step S423). The supplement determination unit 54 determines whether the total requested mount number is within the maximum mountable number of the mounter device 17 (step S424). For example, for the mounter device 17 with mounter number 1, the maximum mountable number of the mounter device 17 assumes the maximum mountable number of "192" based on the mount count 42B on the front side of "96" and the mount count 42C on the rear side of "96", with reference to the mounter device DB 42.

When the total requested mount number is within the maximum mountable number of the mounter device 17 (Yes in step S424), the supplement determination unit 54 determines that all the jigs 20 for all the electronic parts 20A to be supplemented are able to be mounted on the mounter device 17 at a time. Then, the supplement determination unit 54 specifies the part IDs of all the electronic parts 20A to be supplemented as being reported (step S425).

The fourth display control unit 58 in the control unit 35 acquires the jig ID 45A and the location 45E of the jig 20 mounting the electronic part 20A with the specified part ID 45B to be reported from the jig-part combination DB 45 (step S426). When acquiring the jig ID 45A and the location 45E of the jig 20 with the specified part ID 45B to be reported, the fourth display control unit 58 acquires the RF tag ID 47D of the jig 20 with the jig ID 45A (47A) from the jig-RF tag combination DB 47 (step S427).

The fourth display control unit 58 acquires the antenna ID 48A corresponding to the acquired location 45E (48B) of the waiting station 15 from the RF antenna DB 48. Then, the fourth display control unit 58 transmits a command of lighting the display light 15A of the waiting station 15 based on the acquired antenna ID 48A (step S428). The display light 15A of the waiting station 15 is lit in response to the command. Consequently, the worker is able to identify the waiting station 15 in which the jig 20 for the electronic part 20A to be supplemented is stored in response to the lighting of the display light 15A.

Further, the fourth display control unit 58 transmits a command of emitting the LED 20E based on the antenna ID 48A and the RF tag ID 47D corresponding to the location 48B of the waiting station 15 (step S429). The RF tag 20C of the jig 20 for the electronic part 20A to be supplemented emits the LED 20E in response to the command. Consequently, the worker is able to identify the jig 20 for the electronic part 20A to be supplemented in response to the light emission of the LED 20E.

When the total requested mount number is not within the maximum mountable number of the mounter device 17 (No in step S424), the supplement determination unit 54 determines that all the jigs 20 for all the electronic parts 20A to be supplemented are not mountable on the mounter device 17 at a time. Then, the supplement determination unit 54 specifies the part ID 46A of the electronic parts 20A which is running short the earliest among the electronic parts 20A to be supplemented as being reported (step S430). The supplement determination unit 54 repeatedly specifies the jig 20 for the electronic part 20A to be reported among the electronic parts 20A to be supplemented until the vacant mount number of the mounter device 17 reaches zero.

In the processings illustrated in FIG. 15, when a jig 20 for an electronic part 20A to be supplemented is present in the waiting station 15, the LED 20E of the RF tag 20C of the jig 20 for the electronic part 20A to be supplemented is emitted. Consequently, the worker is able to easily identify the jig 20 for the electronic part 20A to be supplemented.

In the processings illustrated in FIG. 15, when a jig 20 for an electronic part 20A to be supplemented is present in the waiting station 15, the display light 15A of the waiting station 15 is lit. Consequently, the worker is able to easily identify the waiting station 15 in which the jig 20 for the electronic part 20A to be supplemented is present.

In the processings illustrated in FIG. 15, when the number of remaining electronic parts 20A of the jigs 20 mounted on the mounter device 17 is less than the number requested to achieve the future production plans, the LED 20E of the RF tag 20C of the jig 20 mounting the electronic part 20A to be supplemented is emitted. Consequently, the worker is able to easily identify the jig 20 for the electronic part 20A to be supplemented from the waiting station 15, thereby efficiently performing the work of supplementing the electronic parts 20A.

When a jig 20 mounting a new electronic part 20A to be mounted on the mounter device 17 is present, the part operation support device 11 according to the present embodiment emits the LED 20E of the RF tag 20C of the jig 20. The part operation support device 11 reports the jig 20 to be mounted on the mounter device 17 which is stored in the waiting station 15 to the worker through the light emission of the LED 20E. Consequently, the worker is able to easily identify the jig 20 for the electronic part 20A to be mounted, thereby efficiently performing the stage change work.

Further, the part operation support device 11 lights the display light 15A of the waiting station 15 in which the jig 20 for the new electronic part 20A to be mounted on the mounter device 17 is stored. Consequently, the worker is able to identify the waiting station 15 in which the jig 20 for the electronic part 20A to be mounted is stored from among the waiting stations 15, thereby efficiently performing the stage change work.

Further, when the number of remaining electronic parts 20A of the jigs 20 mounted on the mounter device 17 is less than the number requested to achieve the future production plans, the part operation support device 11 emits the LED 20E of the RF tag 20C of the jig 20 mounting the electronic part 20A to be supplemented. The part operation support device 11 reports the jig 20 mounting the electronic part 20A to be supplemented which is stored in the waiting station 15 to the worker through the light emission of the LED 20E. Consequently, the worker is able to easily identify the jig 20 for the electronic part 20A to be supplemented from the waiting station 15, thereby efficiently performing the work of supplementing the electronic parts 20A.

Further, the part operation support device 11 lights the display light 15A of the waiting station 15 in which the jig 20 mounting the electronic part 20A to be supplemented is stored. Consequently, the worker is able to identify the waiting station 15 in which the jig 20 for the electronic part 20A to be supplemented is stored from the waiting stations 15, thereby efficiently performing the work of supplementing the electronic parts 20A.

The part operation support device 11 emits the LED 20E of the RF tag 20C of the jig 20 mounting the electronic part 20A other than the electronic parts 20A common in the future production plans among the jigs 20 mounted on the mounter device 17. The part operation support device 11 reports the jig 20 for the electronic part 20A to be removed from the mounter device 17 to the worker. Consequently, the worker is able to easily identify the jig 20 for the electronic part 20A to be removed from the mounter device 17, thereby efficiently performing the stage change work.

The part operation support device 11 emits the LED 20E of the RF tag 20C of the jig 20 mounting the moisture absorption management part for which the out-of-storage time does not exceed the moisture absorption management time. Consequently, the worker is able to prevent the electronic part 20A for which the moisture absorption management time is exceeded from being erroneously used.

Further, the part operation support device 11 blinks the LED 20E of the RF tag 20C of the jig 20 mounting the moisture absorption management part for which the out-of-storage time exceeds the moisture absorption management time. Consequently, the worker is able to prevent the electronic part 20A for which the moisture absorption management time is exceeded from being left.

The part operation support device 11 emits the LED 20E of the RF tag 20C of the jig 20 for the part to be disassembled, which is not scheduled to be operated in the future production plans, for the electronic parts 20A in the waiting station 15. Consequently, the worker is able to easily identify the jig 20 for the part to be disassembled, thereby efficiently performing the stage change work.

The part operation support device 11 according to the present embodiment has been described by way of the free arrangement system operation, but is applicable to the fixed arrangement system operation. In this case, the part operation support device 11 emits the LEDs 20E of the RF tags 20C of the jigs 20 for the electronic parts 20A to be mounted on the mounter device 17 in ascending order of address number of the mount positions. Consequently, the worker is able to easily identify the jigs 20 for the electronic parts 20A from the waiting station 15 even when they are not arranged by plan or in mounting order.

In the present embodiment, when the number of remaining electronic parts 20A in the jigs 20 mounted in the mounter device 17 is less than the number requested to achieve the plan, the LED 20E of the RF tag 20C of the jig 20 for the part to be supplemented, which is not mounted on the mounter device 17, is emitted. However, a predetermined number to be compared with the number of remaining electronic parts 20A of the jigs 20 mounted on the mounter device 17 is not limited to the number requested to achieve the plan.

In the fixed arrangement system operation, when lighting the display light 15A of the waiting station 15 in which the jig 20 for the electronic part 20A to be supplemented is stored, the part operation support device 11 may display the address number of the mount position of the jig 20 on the display unit 15B of the waiting station 15. Similarly, when lighting the display light 15A of the waiting station 15 in which the jig 20 for the electronic part 20A to be mounted on the mounter device 17 is stored, the part operation support device 11 may display the address number of the mount position of the jig 20 on the display unit 15B of the waiting station 15. In this case, the worker is able to recognize the mount position of the jig 20 based on the contents of the display unit 15B, thereby enhancing the work efficiency.

The part operation support device 11 according to the present embodiment has been described by way of the free arrangement system operation, but may be switched from the free arrangement system to the fixed arrangement system or may be switched from the fixed arrangement system to the free arrangement system.

The part operation support device 11 may change the color of the LED 20E to be emitted among a jig 20 for a part to be removed, a jig 20 for a part to be mounted, a jig 20 for a part to be disassembled, and a jig 20 for a part to be supplemented. For example, the part operation support device 11 may assume the jig 20 for the part to be removed in white, the jig 20 for the part to be mounted in blue, the jig 20 for the part to be disassembled in red, and the jig 20 for the part to be supplemented in green.

The part operation support device 11 has been described as supporting the stage change work on one mounter device 17, but is not limited thereto. For example, the part operation support device 11 may support the stage change work on a plurality of mounter devices 17. In this case, the electronic part 20A mounted on the mounter device 17 may be changed in color or light emission frequency of the LED 20E emitted per mounter device 17 for mount, thereby notifying the mounter device 17 for mount and the electronic part 20A to the worker.

The part operation support device 11 is connected to the database 12 storing various DB therein to collect the contents of various DB from the database 12, but various DB may be stored in the storage unit 34. Various DB may be stored in a physical medium which is readable and portable by the part operation support device 11, such as flexible disk (FD), CD-ROM, MO disk, DVD disk, magnetooptical disk or IC card.

All or part of the processings described as being automatically performed, among the processings described in the present embodiment, may be manually performed. Alternatively, all or part of the processings described as being manually performed may be automatically performed in a well-known method. In addition, the processing procedures, the control procedures and the specific names described in the specification and the drawings may be arbitrarily changed unless otherwise stated.

The illustrated respective constituents do not necessarily need to be physically configured as illustrated. That is, the specific forms of distribution and integration of the respective units are not limited to the illustrated ones, and all or part of the units may be functionally or physically distributed or integrated in any unit according to various loads or use situations.

All or any part of various processing functions performed in each device may be performed on a CPU (Central Processing Unit) (or a microcomputer such as MPU (Micro Processing Unit) or MCU (Micro controller unit)). All or any part of various processing functions may be performed in wired logic hardware on programs analyzed and executed by the CPU (or microcomputer such as MPU or MCU).

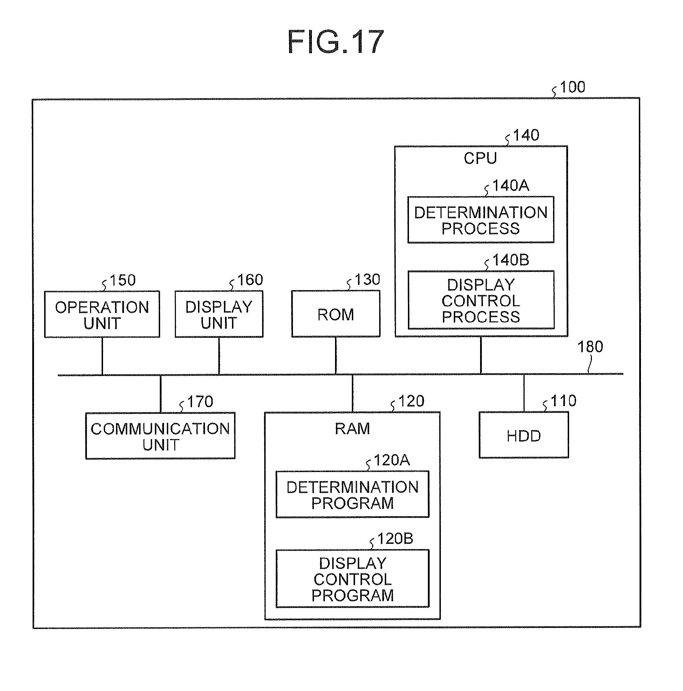

Various processings described in the present embodiment may be realized by executing the previously-prepared programs in a computer. An exemplary computer that executes the programs having the same functions as the present embodiment will be described below. FIG. 17 is an explanatory diagram illustrating an exemplary computer that executes a part operation support program.

A computer 100 that executes the part operation support program illustrated in FIG. 17 includes an HDD (Hard Disk Drive) 110, an RAM (Random Access Memory) 120, an ROM (Read Only Memory) 130 and a CPU 140. The computer 100 further includes an operation unit 150, a display unit 160 and a communication unit 170. In the computer 100, the HDD 110, the RAM 120, the ROM 130, the CPU 140, the operation unit 150, the display unit 160 and the communication unit 170 are connected via a bus 180.

The HDD 110 previously stores therein the part operation support program that serves the same functions as the present embodiment. The part operation support program may be recorded not in the HDD 110 but in a computer readable recording medium such as the ROM 130 or a drive (not illustrated). The recording medium may be a portable recording medium such as CD-ROM, DVD disk or USB memory, or a semiconductor memory such as flash memory. The part operation support program is a determination program 120A and a display control program 120B as illustrated in FIG. 17. The programs 120A and 120B may be integrated or distributed as needed similarly as in the respective constituents in the control unit 35 illustrated in FIG. 3.

Then, the CPU 140 reads the programs 120A and 120B from the HDD 110 and transfers them onto the RAM 120 thereby to perform a determination process 140A and a display control process 140B. FIG. 17 illustrates how each program 120A or 120B is transferred onto the RAM 120. The CPU 140 may execute the programs 120A and 120B while reading them from the HDD 110.

The HDD 110 stores therein an identifier that identifies a part to be mounted on a substrate unit by use of a part mount device and an identifier that identifies a jig which is mountable on the part mount device and is capable of mounting the part in a corresponding manner. The CPU 140 determines whether the total number of parts mounted on one or more jigs mounted on the part mount device is less than a predetermined number. When the total number of parts is less than the predetermined number, the CPU 140 specifies an identifier of the jig which is not mounted on the part mount device and is mounting the part from the HDD 110. Then, the CPU 140 controls a display unit of the jig having the specified identifier. Consequently, the worker is able to reduce workloads in searching a jig through the identification display of the jigs mounting the parts of which the total number is less than the predetermined number.

According to one embodiment, it is possible to alleviate workloads when searching parts to be supplemented or parts whose total number is less than a predetermined number.

## Claims

1. A jig specification support device (11) comprising:
a storage unit (12) that stores therein a first identifier which identifies a part (20A) to be mounted on a substrate unit using a part mount device (17) and a second identifier which identifies a jig (20) mountable on the part mount device (17) and capable of mounting the part (20A) in association with the first identifier;
a determination unit (54) that determines whether total number of parts (20A) mounted on one or more jigs (20) mounted on the part mount device (17) is less than a predetermined number; and
a display control unit (58) that, when the determination unit (54) determines that the total number of parts is less than the predetermined number, specifies in the storage unit (12) the second identifier of the jig (20) which is not mounted on the part mount device (17) and is mounting the part (20A), and controls a display unit (20E) of the jig (20) having the specified second identifier.

2. The jig specification support device (11) according to claim 1, wherein the predetermined number of the determination unit (54) is the number requested to achieve a production plan of the substrate unit.

3. The jig specification support device (11) according to claim 1 or 2, wherein the storage unit (12) stores an identifier which identifies a storage location (15) of the jig (20) in association with the second identifier, and
the display control unit (58) specifies in the storage unit (12) an identifier of the storage location (15) corresponding to the specified second identifier, and identifies and displays a display light (15A) of the storage location (15) based on the specified identifier of the storage location (15).

4. The jig specification support device (11) according to claim 1 or 2, wherein the storage unit (12) stores the number of stock parts to be mounted on the jig (20) in association with the second identifier, and
the display control unit (58) specifies in the storage unit (12) the second identifier of the jig (20) which is not mounted on the part mount device (17) and is mounting the part (20A) based on the number of stock parts.

5. The jig specification support device (11) according to claim 2, comprising a detection unit (54) that detects a vacant mount position of the jig (20) which is not mounted on the part mount device (17),
wherein the display control unit (58) preferentially specifies the second identifier of the jig (20) mounting the part (20A) within the number of the vacant mount positions detected by the detection unit (54) in an order in which the total number of parts (20A) in the jig (20) runs short before the production plan is achieved.

6. A jig specification support method that causes a jig specification support device (11) that specifies a jig (20) which is mountable on a part mount device (17) mounting a part (20A) on a substrate unit and is mounting the part (20A), to perform processings comprising:
determining, using a processor, whether total number of parts (20A) mounted on one or more jigs (20) mounted on the part mount device (17) is less than a predetermined number;
referring to, using the processor, a storage unit (12) that stores a first identifier which identifies the part (20A) and a second identifier which identifies the jig (20) mountable on the part mount device (17) and capable of mounting the part (20) in association with the first identifier;
specifying, using the processor, the second identifier of the jig (20) which is not mounted on the part mount device (17) and is mounting the part (20A), when the total number of parts is less than the predetermined number;
and controlling, using the processor, a display unit (20E) of the jig having the specified second identifier.

7. A jig specification support program that causes a computer to perform processings comprising:
determining whether total number of parts (20A) mounted on one or more jigs (20) mounted on a part mount device (17) mounting a part on a substrate unit is less than a predetermined number;
referring to a storage unit (12) that stores a first identifier which identifies the part (20A) and a second identifier which identifies the jig (17) mountable on the part mount device (17) and capable of mounting the part (20A) in association with the first identifier;
specifying the second identifier of the jig (20) which is not mounted on the part mount device (17) and is mounting the part (20A), when the total number of parts (20A) is less than the predetermined number;
and controlling a display unit (20E) of the jig (20) having the specified second identifier.
